# EUROPEAN PATENT APPLICATION

(11) **EP 4 751 974 A1**
(43) Date of publication of application: **03.06.2026**
(21) Application number: 25218931.1
(22) Date of filing: 27.11.2025
(51) Int. Cl.: B60L 1/00, B60L 1/02, B60L 1/14, B60L 15/00, B60L 50/60, B60L 53/16, B60L 53/20, B60L 53/22, B60L 53/30, H02J 7/02, H02J 7/70, H02M 3/00, H02M 7/00, H05K 1/14, H05K 5/02, H05K 7/14, H05K 7/20

(54) **ALL-IN-ONE VEHICLE-MOUNTED POWER SUPPLY APPARATUS AND POWERTRAIN**

(30) Priority: 30.11.2024 CN 202411767287
(71) Applicant: Huawei Digital Power Technologies Co., Ltd., Shenzhen, Guangdong 518043 (CN)
(72) Inventor: Cai, Hao, Shenzhen, 518043 (CN); Feng, Ningbo, Shenzhen, 518043 (CN); Wang, Tianyu, Shenzhen, 518043 (CN)
(74) Representative: Gill Jennings & Every LLP

(57) **Abstract**

This application provides an all-in-one vehicle-mounted power supply apparatus and a powertrain. The vehicle-mounted power supply apparatus includes a motor control unit, an on-board charger, and a direct current to direct current conversion circuit. A housing of the vehicle-mounted power supply apparatus is configured to accommodate a first circuit board and a second circuit board. An electrical component of the vehicle-mounted power supply apparatus is separately fastened on at least one of the first circuit board and the second circuit board. An electrical component fastened on the first circuit board includes a first interface and a second interface, and an electrical component fastened on the second circuit board includes a third interface. The on-board charger is configured to receive, through the first interface, power supplied by an external power supply, and charge a power battery through the second interface. The motor control unit is configured to receive, through the second interface, power supplied by the power battery, and is configured to drive a drive motor. The direct current to direct current conversion circuit is configured to supply power to a vehicle-mounted load of an electric vehicle through the third interface. According to the all-in-one vehicle-mounted power supply apparatus provided in this application, electrical components are properly arranged via two circuit boards, thereby improving integration and reducing an overall size.

## Description

### TECHNICAL FIELD

This application relates to the field of vehicle technologies, and specifically, to an all-in-one vehicle-mounted power supply apparatus and a powertrain.

### BACKGROUND

A vehicle-mounted power supply apparatus is configured to receive a high-voltage charging current to charge a power battery, and is further configured to receive the high-voltage charging current or a current of the power battery to supply power to other electric devices in a vehicle. As functions of the electric vehicle are continuously increased, integration of the vehicle-mounted power supply apparatus is gradually improved, resulting in a rapid increase in size and affecting layout in the vehicle.

### SUMMARY

This application provides an all-in-one vehicle-mounted power supply apparatus and a powertrain. Electrical components are properly arranged and fastened via two circuit boards of the vehicle-mounted power supply apparatus, to improve integration of the vehicle-mounted power supply apparatus and reduce a size.

According to a first aspect, this application provides an all-in-one vehicle-mounted power supply apparatus. The vehicle-mounted power supply apparatus is used in an electric vehicle. The vehicle-mounted power supply apparatus includes a motor control unit, an on-board charger, and a direct current to direct current conversion circuit. A housing of the vehicle-mounted power supply apparatus includes an accommodation groove, and the accommodation groove is configured to accommodate a first circuit board and a second circuit board. An electrical component of the motor control unit, an electrical component of the on-board charger, and an electrical component of the direct current to direct current conversion circuit are separately fastened on at least one of the first circuit board and the second circuit board. An electrical component fastened on the first circuit board includes a first interface and a second interface, and an electrical component fastened on the second circuit board includes a third interface. The on-board charger is configured to receive, through the first interface, an alternating current provided by an external power supply, and output, through the second interface, a direct current to charge a power battery. The motor control unit is configured to receive, through the second interface, a direct current output by the power battery of the electric vehicle, and output an alternating current to drive a drive motor of the electric vehicle. The direct current to direct current conversion circuit is configured to supply power to a vehicle-mounted load of the electric vehicle through the third interface.

According to the all-in-one vehicle-mounted power supply apparatus provided in this application, the first circuit board and the second circuit board are accommodated in the accommodation groove, and the electrical component of the motor control unit, the electrical component of the on-board charger, and the electrical component of the direct current to direct current conversion circuit are fastened via the first circuit board and the second circuit board. The all-in-one vehicle-mounted power supply apparatus provided in this application is further electrically connected to the external power supply, the power battery, and the vehicle-mounted load through the first interface, the second interface, and the third interface respectively. Therefore, the vehicle-mounted power supply apparatus in this application integrates functions of driving the drive motor, receiving power supplied by the external power supply to charge the power battery, and receiving power supplied by the power battery to supply the vehicle-mounted load.

The electrical component fastened on the first circuit board includes the first interface and the second interface, and the first circuit board is configured to fasten the electrical component of the on-board charger. The electrical component fastened on the second circuit board includes the third interface, and the second circuit board is configured to fasten the electrical component of the direct current to direct current conversion circuit and the electrical component of the motor control unit. According to the all-in-one vehicle-mounted power supply apparatus provided in this application, electrical components are properly arranged via two circuit boards, thereby improving integration and reducing an overall size.

In an implementation, an area of the second circuit board is less than a half of that of the first circuit board, and the second circuit board is arranged between a housing bottom of the housing and the first circuit board.

In this implementation, the area of the first circuit board is compared with the area of the second circuit board, so that more electrical components can be integrated into the first circuit board, and the area of the second circuit board is reduced to save internal space of the accommodation groove. The second circuit board is arranged between the housing bottom of the housing and the first circuit board, so that space may be reserved between the first circuit board and the housing bottom of the housing, to accommodate a part of electrical components with a large size.

In an implementation, the direct current to direct current conversion circuit includes a primary-side circuit, a first transformer, and a secondary-side circuit, the electrical component fastened on the first circuit board further includes an electrical component of the primary-side circuit, the electrical component fastened on the second circuit board further includes an electrical component of the secondary-side circuit, and the first transformer is configured to electrically connect the electrical component of the primary-side circuit borne on the first circuit board and the electrical component of the secondary-side circuit borne on the second circuit board.

In this implementation, the primary-side circuit of the direct current to direct current conversion circuit is electrically connected to the secondary-side circuit via the first transformer. The electrical component of the primary-side circuit and the electrical component of the secondary-side circuit are conveniently fastened on the first circuit board and the second circuit board respectively, and are electrically connected via the first transformer. The first transformer has a large size, and the first transformer and the second circuit board are together arranged between the first circuit board and the housing bottom of the housing. The all-in-one vehicle-mounted power supply apparatus provided in this application has a more compact structure, which facilitates heat dissipation of the first transformer.

In an implementation, a height of the first transformer is less than a spacing between the first circuit board and a groove bottom of the accommodation groove, and is greater than a spacing between the second circuit board and the groove bottom of the accommodation groove. The second circuit board and the first transformer are spaced in a first direction.

In this implementation, the second circuit board and the first transformer are disposed side by side in the first direction, to shorten a connection distance between the second circuit board and the first transformer.

In an implementation, the first transformer is plug-connected to the first circuit board, and the first transformer is screw-connected to the second circuit board.

In this implementation, the plug-connection between the first transformer and the first circuit board facilitates installation, and the screw-connection between the first transformer and the second circuit board is firm, so that the first transformer may be connected to the second circuit board and then fastened on the first circuit board together with the second circuit board.

In an implementation, the electrical component fastened on the first circuit board further includes the electrical component of the on-board charger, and the on-board charger includes an alternating current to direct current conversion circuit. An input end of the alternating current to direct current conversion circuit is configured to receive the alternating current provided by the external power supply, and an output end of the alternating current to direct current conversion circuit is configured to output a direct current to the primary-side circuit of the direct current to direct current conversion circuit via an on-board circuit on the first circuit board. In the first direction, the electrical component of the on-board charger is arranged between the first interface and the electrical component of the primary-side circuit of the direct current to direct current conversion circuit.

In this implementation, the electrical component of the on-board charger is fastened on the first circuit board. The output end of the alternating current to direct current conversion circuit is configured to output the direct current via the primary-side circuit. The electrical component of the on-board charger and the primary-side circuit are arranged in the first direction, and the electrical component of the on-board charger and the primary-side circuit are close to each other and located on a same side of the first circuit board, so that the electrical component of the on-board charger is electrically connected to the primary-side circuit, heat of the first circuit board is concentrated, and a heat dissipation structure is conveniently arranged.

In an implementation, the accommodation groove includes a first mounting hole, a second mounting hole, a third mounting hole, and a fourth mounting hole, the first mounting hole and the second mounting hole are distributed on a first side wall of the accommodation groove, the third mounting hole and the fourth mounting hole are distributed on a second side wall of the accommodation groove, and the first circuit board and the second circuit board are stacked between the first side wall and the second side wall. The first mounting hole is configured to install a first connector, and the first connector is configured to electrically connect the first interface and the external power supply. The second mounting hole is configured to install a second connector, and the second connector is configured to electrically connect the second interface and the power battery. The third mounting hole is configured to install a third connector, and the third connector is configured to electrically connect the third interface and the vehicle-mounted load. A three-phase copper bar of the vehicle-mounted power supply apparatus is connected to the motor through the fourth mounting hole, and the vehicle-mounted power supply apparatus supplies power to the motor via the three-phase copper bar. A spacing between the first mounting hole and the second mounting hole in the first side wall is greater than a spacing between the third mounting hole and the fourth mounting hole in the second side wall.

In this implementation, each mounting hole is configured to install the connector, so that each interface of the electrical component communicates with the outside via the connector. The first mounting hole and the second mounting hole are located on a same side of the first circuit board, and are close to the on-board charger in the first direction, so that the first interface and the second interface are electrically connected to the outside via the first connector and the second connector respectively. The third mounting hole and the fourth mounting hole are located on the other side of the first circuit board, and are close to the direct current to direct current conversion circuit in the first direction, so that the third interface is connected to the vehicle-mounted load via the third connector.

However, the first interface and the second interface are configured to transmit a high-voltage alternating current and a high-voltage direct current respectively, and a large distance between the first mounting hole and the second mounting hole can reduce interference between the high-voltage currents. The fourth mounting hole is close to the drive motor, and a distance between the third mounting hole and the fourth mounting hole is shorter, so that the third connector provides a low-voltage direct current for a component, for example, a rotating transformer of the drive motor.

In an implementation, the accommodation groove includes a coolant inlet and a coolant outlet, the coolant inlet is distributed on a third side wall of the accommodation groove, the coolant outlet is distributed on a fourth side wall of the accommodation groove, the first circuit board and the second circuit board are stacked between the third side wall and the fourth side wall, in a second direction, a distance between the coolant inlet and the second mounting hole is less than a distance between the coolant outlet and the second mounting hole, and the second direction is perpendicular to the first direction.

In this implementation, the all-in-one vehicle-mounted power supply apparatus provided in this application further dissipates heat through a coolant, and the coolant inlet and the coolant outlet are formed on the housing for circulation of the coolant in the accommodation groove. The coolant inlet and the coolant outlet are located on two opposite side walls of the housing in the second direction, to avoid a plurality of mounting holes and a plurality of connectors in the first side wall and the second side wall, thereby ensuring safety of the vehicle-mounted power supply apparatus.

If the coolant inlet is closer to the second mounting hole than the coolant outlet, the coolant inlet is closer to the motor control unit, and cooling effect of the motor control unit is preferentially ensured.

In an implementation, the coolant inlet is configured to communicate with the coolant outlet sequentially via a first heat dissipation plate and a second heat dissipation plate. The first heat dissipation plate and the second heat dissipation plate are arranged between the housing and a cover plate. An orthographic projection of the first heat dissipation plate on the first circuit board at least partially overlaps with the drive motor control unit of the vehicle-mounted power supply apparatus. An orthographic projection of the second heat dissipation plate on the first circuit board at least partially overlaps with the on-board charger.

In this implementation, the vehicle-mounted power supply apparatus provided in this application includes the first heat dissipation plate and the second heat dissipation plate. The first heat dissipation plate is configured to dissipate heat for the motor control unit, and the second heat dissipation plate is configured to dissipate heat for the on-board charger. A water inlet close to the motor control unit communicates with a water outlet sequentially via the first heat dissipation plate and the second heat dissipation plate. This ensures reliable heat dissipation of the motor control unit and implements heat dissipation for the on-board charger.

In an implementation, the electrical component fastened on the first circuit board further includes the electrical component of the motor control unit, the electrical component of the motor control unit includes a power module, and the power module is fastened on a surface that is of the first circuit board and that faces the bottom of the accommodation groove. An input end of the power module is configured to receive, through the second interface, the direct current provided by the power battery, and an output end of the power module is configured to output an alternating current to the motor.

In this implementation, the electrical component of the motor control unit is fastened on the first circuit board, so that the motor control unit receives, through the second interface, power supplied by the power battery. The power module of the motor control unit is fastened on a side that is of the first circuit board and that faces the housing bottom of the housing, so that the power module is electrically connected to the drive motor, and the all-in-one vehicle-mounted power supply apparatus provided in this application has a more compact structure.

In an implementation, in the first direction, the power module is arranged between the second interface and the fourth mounting hole.

In an implementation, the vehicle-mounted power supply apparatus includes a three-phase copper bar adapter base, the output end of the power module is connected to the three-phase copper bar through the three-phase copper bar adapter base, the alternating current output by the output end of the power module to the motor passes through the three-phase copper bar adapter base and the three-phase copper bar, the three-phase copper bar adapter base is fastened between the power module and the bottom of the accommodation groove, one end of the three-phase copper bar adapter base is fastened to the output end of the power module, the other end of the three-phase copper bar adapter base is connected to the three-phase copper bar via three screws, and in a direction in which the bottom of the accommodation groove and the first circuit board are stacked, projections of the three screws fall into three corresponding through holes in the first circuit board.

In this implementation, the motor control unit is electrically connected to the drive motor via the three-phase copper bar, the three-phase copper bar is located on the side that is of the first circuit board and that faces the housing bottom of the housing, and the three-phase copper bar adapter base is configured to electrically connect the three-phase copper bar and the power module that are located on a same side, so that the vehicle-mounted power supply apparatus has a more compact structure. The three through holes in the first circuit board are used to avoid the three screws used to connect the three-phase copper bar adapter base and the three-phase copper bar, to facilitate installation, removal, and maintenance between the three-phase copper bar adapter base and the three-phase copper bar.

In an implementation, the vehicle-mounted power supply apparatus includes one capacitor module, the capacitor module is configured to reduce electromagnetic radiation of the direct current input by the power battery to the motor control unit, the capacitor module includes a magnetic ring and a capacitor, the capacitor module and the three-phase copper bar adapter base are adjacently fastened between the first circuit board and the bottom of the accommodation groove, and a projection of the capacitor module on the first circuit board at least partially overlaps with the electrical component of the motor control unit.

In this implementation, a side of the three-phase copper bar adapter base is configured to fasten one capacitor module, and the capacitor module and the electrical component of the motor control unit are at least partially overlapped, so that a transmission distance between the capacitor module and the motor control unit can be shortened, and the vehicle-mounted power supply apparatus has a more compact structure.

In an implementation, the vehicle-mounted power supply apparatus further includes a shielding plate, the shielding plate is configured to shield electromagnetic interference between any two of the electrical component of the motor control unit, the electrical component of the on-board charger, and the electrical component of the direct current to direct current conversion circuit, and the shielding plate is fastened between the bottom of the accommodation groove and the first circuit board. A first shielding wall of the shielding plate presses against a metal part that is on the first circuit board and that faces the bottom of the accommodation groove, the electrical component of the motor control unit is fastened on one side of the first shielding wall, and the electrical component of the on-board charger and the electrical component of the direct current to direct current conversion circuit are fastened on the other side of the first shielding wall. A second shielding wall of the shielding plate is arranged between the first interface and the third interface, the electrical component of the on-board charger is fastened on one side of the second shielding wall, and the first transformer of the direct current to direct current conversion circuit and the electrical component of the secondary-side circuit are fastened on the other side of the second shielding wall.

In this implementation, the vehicle-mounted power supply apparatus implements electromagnetic shielding between the electrical components via the shielding plate. The first shielding wall roughly extends in the first direction, and is configured to shield electromagnetic interference between the motor control unit, the on-board charger, and the direct current to direct current conversion circuit. The second shielding wall roughly extends in the second direction, the second shielding wall is located on a side that is of the first shielding wall and that faces the on-board charger and the direct current to direct current conversion circuit, and the second shielding wall is configured to shield electromagnetic interference between the on-board charger and the direct current to direct current conversion circuit.

The metal part that is on the first circuit board and that faces the housing bottom of the housing is configured to press against the shielding plate, to avoid affecting shielding effect due to leakage of an electromagnetic signal from a gap between the first circuit board and the shielding plate.

In an implementation, the vehicle-mounted power supply apparatus includes a compressor controller or a second direct current to direct current conversion circuit, the second direct current to direct current conversion circuit is configured to output a direct current for power supply, the electrical component fastened on the first circuit board further includes an electrical component of the compressor controller or an electrical component of the second direct current to direct current conversion circuit and a fifth interface, the accommodation groove further includes a fifth mounting hole, the fifth mounting hole is distributed on a side wall of the accommodation groove, the fifth mounting hole is configured to install a fifth connector, the fifth connector is configured to electrically connect an air conditioner compressor or a vehicle heater and the fifth interface, and the fifth interface is fastened between the first interface and the second interface.

In this implementation, the first circuit board is further configured to fasten the electrical component of the compressor controller or the electrical component of the second direct current change circuit. In this application, the all-in-one vehicle-mounted power supply apparatus is further configured to connect to a cockpit heater or the air conditioner compressor through the fifth interface, thereby further improving integration of the vehicle-mounted power supply apparatus.

In an implementation, the fifth mounting hole is distributed in the first side wall of the accommodation groove, and a spacing between the first mounting hole and the fifth mounting hole in the first side wall is less than a spacing between the second mounting hole and the fifth mounting hole.

In an implementation, the housing of the vehicle-mounted power supply apparatus further includes the cover plate and an end cover, the cover plate is configured to enclose the accommodation groove, the cover plate includes a hollow area, and the end cover is configured to enclose the hollow area. The accommodation groove is further configured to accommodate at least one fuse, the at least one fuse is configured to electrically connect the second interface and at least one of the electrical component of the motor control unit, the electrical component of the compressor controller, or the electrical component of the second direct current to direct current conversion circuit, and the at least one fuse is configured to perform disconnection protection on the at least one of the electrical component of the motor control unit, the electrical component of the compressor controller, or the electrical component of the second direct current to direct current conversion circuit. The cover plate and the first circuit board are stacked, and in a direction in which the cover plate and the first circuit board are stacked, a projection area of the hollow area covers the at least one fuse.

In this implementation, the first circuit board is close to the cover plate, and the detachable end cover is disposed on the cover plate to expose the fuse, so that each fuse can be maintained and replaced without removing the entire cover plate, thereby improving maintenance convenience of the vehicle-mounted power supply apparatus provided in this application.

In an implementation, the vehicle-mounted power supply apparatus includes a vehicle control unit. The electrical component fastened on the first circuit board further includes an electrical component of the vehicle control unit and a sixth interface, the electrical component of the motor control unit is fastened between the sixth interface and the second interface, and the vehicle control unit is configured to transmit a control signal through the sixth interface to control a vehicle-mounted device. The accommodation groove further includes a sixth mounting hole, the sixth mounting hole is distributed at the bottom of the accommodation groove, the sixth mounting hole is configured to install a sixth connector, and the sixth connector is configured to electrically connect the sixth interface and the vehicle-mounted device.

In this implementation, the first circuit board is further configured to fasten the electrical component of the vehicle control unit and the sixth interface. In this application, the all-in-one vehicle-mounted power supply apparatus is further configured to output the control signal through the sixth interface to control the vehicle-mounted device of the electric vehicle, thereby further improving integration of the vehicle-mounted power supply apparatus.

In an implementation, the vehicle-mounted device of the electric vehicle includes one or more of a throttle pedal, a brake pedal, a light, a steering device, and an air conditioner.

In an implementation, the vehicle-mounted power supply apparatus includes a filter, the first circuit board is configured to fasten an electrical component of the filter, and the filter is configured to implement electromagnetic shielding between other electrical components in the vehicle-mounted power supply apparatus.

In an implementation, the electrical component of the filter includes a plurality of magnetic components.

In an implementation, the primary-side circuit and the vehicle control unit are spaced in the second direction.

In this embodiment, on the first circuit board, a spacing distance between the vehicle control unit and the on-board charger is long, so that impact of electromagnetic interference generated when the on-board charger operates on the vehicle control unit can be reduced.

In an implementation, the housing bottom of the housing includes a mechanical limiting interface, and the housing is configured to be fastened to a housing of the drive motor through the mechanical limiting interface.

In this implementation, the vehicle-mounted power supply apparatus provided in this application may be fastened to the housing of the drive motor, so that the three-phase copper bar of the motor control unit in the vehicle-mounted power supply apparatus is electrically connected to the drive motor to improve overall integration of a powertrain.

In an implementation, a side wall of the housing is configured to extend under the housing bottom, and form an accommodating cavity that accommodates the drive motor.

In an implementation, the shielding plate includes a third shielding wall, the electrical component of the on-board charger includes a plurality of common-mode inductors, the plurality of common-mode inductors are spaced in the second direction, and the third shielding wall roughly extends in the first direction and is configured to be arranged between two adjacent common-mode inductors in the second direction.

In an implementation, the vehicle-mounted power supply apparatus includes at least one shielding can, and the at least one shielding can is configured to be fastened on the first circuit board to isolate electromagnetic interference. One shielding can is configured to cover a plurality of pins or pin headers that are electrically connected and that are of the vehicle control unit, the sixth interface, and the sixth connector.

In this implementation, electromagnetic interference generated by the plurality of pins or pin headers that are electrically connected and that are of the vehicle control unit, the sixth interface, and the sixth connector on the first circuit board is large. The shielding can is used to isolate the plurality of pins or pin headers that are electrically connected and that are of the vehicle control unit, the sixth interface, and the sixth connector on the first circuit board, so that electromagnetic interference caused by the vehicle control unit in the vehicle-mounted power supply apparatus to other functional circuits can be reduced, thereby ensuring that the vehicle control unit operates reliably.

In an implementation, one shielding can is configured to cover a plurality of pins or pin headers that are electrically connected and that are of the on-board charger, the first interface, and the first connector.

In this implementation, electromagnetic interference generated by the plurality of pins or pin headers that are electrically connected and that are of the on-board charger, the first interface, and the first connector is large. The shielding can is used to isolate the plurality of pins or pin headers that are electrically connected and that are of the on-board charger, the first interface, and the first connector on the first circuit board, so that electromagnetic interference caused by the on-board charger to other electrical components in the vehicle-mounted power supply apparatus can be reduced, thereby ensuring that the on-board charger operates reliably and ensuring that the vehicle-mounted power supply apparatus in this application meets a safety requirement.

According to a second aspect, this application provides a powertrain. The powertrain includes a drive motor and the vehicle-mounted power supply apparatus provided above, an accommodation groove of the vehicle-mounted power supply apparatus and a housing of the drive motor are of an integrated housing, a bottom of the accommodation groove shares a part of the housing with the housing of the drive motor, the drive motor is connected to the vehicle-mounted power supply apparatus via a three-phase copper bar of the vehicle-mounted power supply apparatus, and the vehicle-mounted power supply apparatus outputs a three-phase current to drive the drive motor to rotate. The powertrain provided in this application separately accommodates the vehicle-mounted power supply apparatus and the drive motor via the integrated housing, so that the powertrain has a more compact structure, and the all-in-one vehicle-mounted power supply apparatus provided in this application is electrically connected to the drive motor via the three-phase copper bar.

### BRIEF DESCRIPTION OF DRAWINGS

To describe technical solutions in this application more clearly, the following briefly describes accompanying drawings used in describing implementations. Clearly, the accompanying drawings in the following descriptions are merely some implementations of this application, and a person of ordinary skill in the art may still derive other drawings from these accompanying drawings without creative efforts.
FIG. 1 is a diagram of a structure of a vehicle-mounted power supply apparatus in an electric vehicle according to an embodiment of this application;
FIG. 2 is a diagram of an application scenario of a vehicle-mounted power supply apparatus 10 according to an embodiment of this application;
FIG. 3 is a block diagram of a structure of a part of electrical components in a vehicle-mounted power supply apparatus 10 according to an embodiment of this application;
FIG. 4 is a diagram of a structure of a vehicle-mounted power supply apparatus 10 according to an embodiment of this application;
FIG. 5 is a diagram of an exploded structure of a vehicle-mounted power supply apparatus 10 according to an embodiment of this application;
FIG. 6 is a diagram of an exploded structure of a vehicle-mounted power supply apparatus 10 from a perspective according to an embodiment of this application;
FIG. 7 is a diagram of an exploded structure of a vehicle-mounted power supply apparatus 10 from another perspective according to an embodiment of this application;
FIG. 8 is diagram of a partial structure of a vehicle-mounted power supply apparatus 10 according to an embodiment of this application;
FIG. 9 is a diagram of a partial structure of a vehicle-mounted power supply apparatus 10 according to an embodiment of this application;
FIG. 10 is a partial exploded diagram of a vehicle-mounted power supply apparatus 10 according to an embodiment of this application;
FIG. 11 is diagram of a partial structure of a vehicle-mounted power supply apparatus 10 according to an embodiment of this application;
FIG. 12 is a partial exploded diagram of a vehicle-mounted power supply apparatus 10 according to an embodiment of this application;
FIG. 13 is a partial exploded diagram of a vehicle-mounted power supply apparatus 10 according to an embodiment of this application;
FIG. 14 is a diagram of a partial structure of a vehicle-mounted power supply apparatus 10 according to an embodiment of this application;
FIG. 15 is a diagram of a partial structure of a vehicle-mounted power supply apparatus 10 according to an embodiment of this application;
FIG. 16 is a partial diagram of a vehicle-mounted power supply apparatus 10 according to an embodiment of this application;
FIG. 17 is a partial exploded diagram of a vehicle-mounted power supply apparatus 10 according to an embodiment of this application;
FIG. 18 is a diagram of a partial structure of a vehicle-mounted power supply apparatus 10 according to an embodiment of this application;
FIG. 19 is a diagram of a partial structure of a vehicle-mounted power supply apparatus 10 according to an embodiment of this application;
FIG. 20 is a diagram of a partial structure of a vehicle-mounted power supply apparatus 10 according to an embodiment of this application;
FIG. 21 is a diagram of a partial structure of a vehicle-mounted power supply apparatus 10 according to an embodiment of this application;
FIG. 22 is a partial exploded diagram of a vehicle-mounted power supply apparatus 10 according to an embodiment of this application;
FIG. 23 is a diagram of a partial structure of a vehicle-mounted power supply apparatus 10 according to an embodiment of this application;
FIG. 24 is a diagram of a partial structure of a vehicle-mounted power supply apparatus 10 according to an embodiment of this application;
FIG. 25 is a partial exploded diagram of a vehicle-mounted power supply apparatus 10 according to an embodiment of this application;
FIG. 26 is a diagram of a partial structure of a vehicle-mounted power supply apparatus 10 according to an embodiment of this application;
FIG. 27 is a diagram of a partial structure of a vehicle-mounted power supply apparatus 10 according to an embodiment of this application;
FIG. 28 is a diagram of a partial structure of a vehicle-mounted power supply apparatus 10 according to an embodiment of this application;
FIG. 29 is a diagram of a partial structure of a vehicle-mounted power supply apparatus 10 according to an embodiment of this application;
FIG. 30 is a partial exploded diagram of a vehicle-mounted power supply apparatus 10 according to an embodiment of this application;
FIG. 31 is a diagram of a partial structure of a vehicle-mounted power supply apparatus 10 according to an embodiment of this application;
FIG. 32 is a partial exploded diagram of a vehicle-mounted power supply apparatus 10 according to an embodiment of this application;
FIG. 33 is a diagram of a partial exploded structure of a vehicle-mounted power supply apparatus 10 according to an embodiment of this application;
FIG. 34 is a partial diagram of a vehicle-mounted power supply apparatus 10 according to an embodiment of this application; and
FIG. 35 is a diagram of a structure of a vehicle-mounted power supply apparatus 10 according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application. All other embodiments obtained by a person of ordinary skill in the art based on embodiments of this application without creative efforts shall fall within the protection scope of this application.

For ease of understanding, the following first explains and describes English abbreviations and related technical terms used in embodiments of this application.

PCB: printed circuit board, refers to a carrier for electrical interconnection of electronic components. Embodiments of this application are implemented via a first circuit board and a second circuit board.

OBC: on-board charger, is a power electronic apparatus that converts an alternating current into a direct current to charge a power battery of an electric vehicle.

DCDC: direct current to direct current, direct current to direct current conversion circuit, converts a direct current power supply of a voltage level into a direct current power supply of another voltage level, to adjust power supply output and stabilize a power supply voltage. For example, a high-voltage direct current output by a power battery of an electric vehicle may be converted into a low-voltage direct current to supply power to other electrical components in the electric vehicle.

PDU: power distribution unit, is mainly responsible for distributing and managing electric energy output by a power battery of an electric vehicle.

MCU: motor control unit, receives a control instruction from a vehicle control unit and controls a rotation speed and a rotation direction of a drive motor.

VCU: vehicle control unit, is a core of an entire control system of an electric vehicle. A main function of the vehicle control unit is to coordinate and manage a running status of the vehicle, including collecting statuses of a drive motor and a power battery, collecting a throttle pedal signal, a brake pedal signal, an actuator signal, and a sensor signal, and monitoring an action of each lower-layer component controller after making a corresponding decision based on comprehensive analysis of an intention of a driver.

In this specification, a "high voltage" and a "low voltage" indicate relative voltage values, a voltage of the "high voltage" is higher than a voltage of the "low voltage", and the "high voltage" and the "low voltage" do not indicate specific voltage values.

This application provides an all-in-one vehicle-mounted power supply apparatus. The vehicle-mounted power supply apparatus is used in an electric vehicle. The vehicle-mounted power supply apparatus includes a motor control unit, an on-board charger, and a direct current to direct current conversion circuit. A housing of the vehicle-mounted power supply apparatus includes an accommodation groove, and the accommodation groove is configured to accommodate a first circuit board and a second circuit board. An electrical component of the motor control unit, an electrical component of the on-board charger, and an electrical component of the direct current to direct current conversion circuit are separately fastened on at least one of the first circuit board and the second circuit board. An electrical component fastened on the first circuit board includes a first interface and a second interface, and an electrical component fastened on the second circuit board includes a third interface. The on-board charger is configured to receive, through the first interface, an alternating current provided by an external power supply, and output, through the second interface, a direct current to charge a power battery. The motor control unit is configured to receive, through the second interface, a direct current output by the power battery of the electric vehicle, and output an alternating current to drive a drive motor of the electric vehicle. The direct current to direct current conversion circuit is configured to supply power to a vehicle-mounted load of the electric vehicle through the third interface. The all-in-one vehicle-mounted power supply apparatus provided in this application integrates functions of driving the drive motor, receiving power supplied by the external power supply to charge the power battery, and receiving power supplied by the power battery to supply power to the vehicle-mounted load. Electrical components are properly arranged via two circuit boards, thereby improving integration and reducing an overall size.

This application provides a powertrain. The powertrain includes a drive motor and the vehicle-mounted power supply apparatus provided above, an accommodation groove of the vehicle-mounted power supply apparatus and a housing of the drive motor are of an integrated housing, a bottom of the accommodation groove shares a part of the housing with the housing of the drive motor, the drive motor is connected to the vehicle-mounted power supply apparatus via a three-phase copper bar of the vehicle-mounted power supply apparatus, and the vehicle-mounted power supply apparatus outputs a three-phase current to drive the drive motor to rotate. The powertrain provided in this application separately accommodates the vehicle-mounted power supply apparatus and the drive motor via the integrated housing, so that the powertrain has a more compact structure, and the all-in-one vehicle-mounted power supply apparatus provided in this application is electrically connected to the drive motor via the three-phase copper bar.

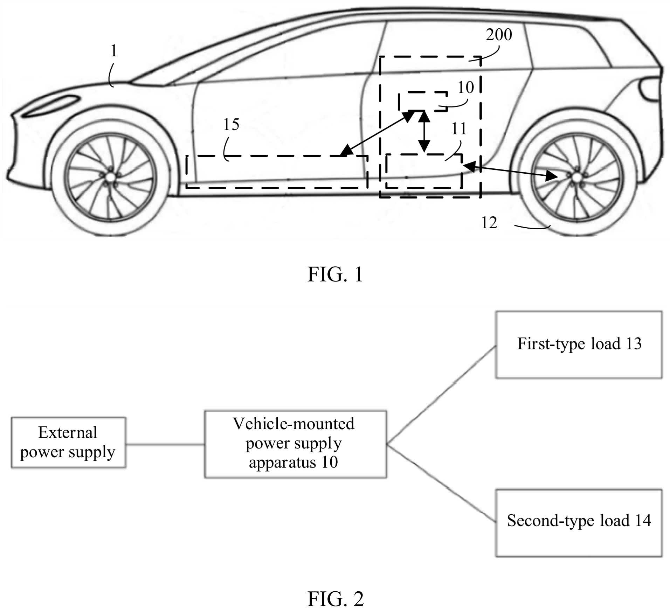

Refer to a diagram of a structure of a vehicle-mounted power supply apparatus in an electric vehicle according to an embodiment of this application shown in FIG. 1.

As shown in FIG. 1, an electric vehicle 1 includes an all-in-one vehicle-mounted power supply apparatus 10 provided in this application. The vehicle-mounted power supply apparatus 10 is configured to be fastened to a vehicle frame, and is configured to electrically connect to electrical components in the electric vehicle 1. The vehicle-mounted power supply apparatus 10 is configured to supply power to the electrical components in the electric vehicle 1.

The electric vehicle 1 is a wheeled electric vehicle 1 that is driven or pulled by a power apparatus and that is used for passengers traveling on a road or for transporting goods and performing special engineering operations. The electric vehicle 1 includes an electric vehicle (Electric Vehicle, EV for short), a pure electric vehicle (Pure Electric Vehicle/Battery Electric Vehicle, PEV/BEV for short), a hybrid electric vehicle (Hybrid Electric Vehicle, HEV for short), a range extended electric vehicle (Range Extended Electric Vehicle, REEV for short), a plug-in hybrid electric vehicle (Plug-in Hybrid Electric Vehicle, PHEV for short), a new energy vehicle (New Energy Vehicle), and the like. In some implementations, the electric vehicle 1 includes a passenger vehicle and various special-purpose vehicles with specific functions, such as an engineering rescue vehicle, a sprinkler, a suction-type sewer scavenger, a cement mixer truck, a crane, and a medical vehicle. The electric vehicle 1 may alternatively be a mobile robot.

For clear description, FIG. 1 is an enlarged diagram of a functional component of the electric vehicle 1, is mainly used to show a connection and a subordinate relationship of the functional component, and does not indicate a specific location, a size, and a relative distance of the functional component.

FIG. 2 is a diagram of an application scenario of a vehicle-mounted power supply apparatus 10 according to an embodiment of this application.

As shown in FIG. 2, electrical components of the electric vehicle 1 include a first-type load 13 and a second-type load 14. The vehicle-mounted power supply apparatus 10 provided in this application is separately configured to electrically connect to an external power supply, the first-type load 13, and the second-type load 14. The vehicle-mounted power supply apparatus 10 receives a high-voltage charging current from the external power supply. In an embodiment, the external power supply may be an alternating current power grid, an alternating current charging pile, or an uninterruptible power system (Uninterruptible Power System, UPS). In this case, the external power supply is an alternating current power supply. The vehicle-mounted power supply apparatus 10 is configured to electrically connect to the external power supply and receive an alternating current. The vehicle-mounted power supply apparatus 10 converts the received alternating current into a direct current and transmits the direct current to the first-type load 13 and the second-type load 14, to supply power to the first-type load 13 and the second-type load 14. In another embodiment, the vehicle-mounted power supply apparatus 10 provided in this application converts a voltage amplitude or frequency of a received alternating current, and outputs another form of alternating current to supply power to another electrical component that needs to operate under the alternating current.

In an embodiment, the first-type load 13 is a high-voltage load. For example, the first-type load 13 is a battery, a compressor, or a heater. When the battery is configured to supply power to an electric motor in a power system of the electric vehicle 1, the battery may also be referred to as a power battery 15. The second-type load 14 is a low-voltage load. For example, the second-type load 14 includes at least one of a low-voltage battery, a light, a windscreen wiper, an air conditioner, a sound system, a USB interface, a dashboard, a control display, and the like. The low-voltage battery may also supply power to another load in the second-type load 14.

In an embodiment, the electric vehicle 1 provided in this application includes a power battery 15. The power battery 15 is configured to be fastened to a vehicle frame, and is configured to electrically connect to the vehicle-mounted power supply apparatus 10. The power battery 15 is configured to receive a charging current via a part of electrical components in the vehicle-mounted power supply apparatus 10, that is, the power battery 15 is configured to receive and store electric energy provided by the vehicle-mounted power supply apparatus 10. The power battery 15 is further configured to supply power to the other part of electrical components in the vehicle-mounted power supply apparatus 10, or supply power to a part of electrical components in the electric vehicle 1, for example, a drive motor 11 in the power system, via a part of electrical components in the vehicle-mounted power supply apparatus 10.

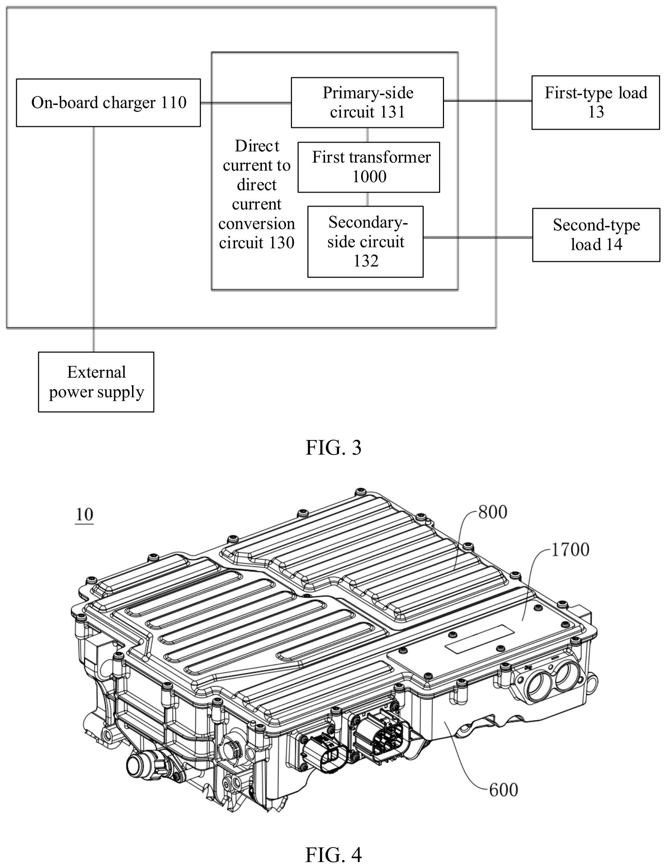

FIG. 3 is a block diagram of a structure of a part of electrical components in a vehicle-mounted power supply apparatus 10 according to an embodiment of this application.

As shown in FIG. 3, the vehicle-mounted power supply apparatus 10 provided in this application includes a power conversion component. The power conversion component is configured to receive an alternating current and output at least two types of direct currents with different voltages. Specifically, the power conversion component includes an on-board charger 110 and a direct current to direct current conversion circuit 130. The on-board charger 110 is configured to receive the alternating current provided by the external power supply, and output the direct current to charge a power battery 15. The direct current to direct current conversion circuit 130 is configured to receive power supplied by the on-board charger 110 or the power battery 15, and supply power to a vehicle-mounted load of the electric vehicle 1.

When the direct current to direct current conversion circuit 130 is configured to receive power supplied by the on-board charger 110, a high-voltage charging current input by the external power supply to the power conversion component is an alternating current, and the alternating current is converted into a direct current by the on-board charger 110 and then transmitted to the direct current to direct current conversion circuit 130. After receiving the direct current output by the on-board charger 110, the direct current to direct current conversion circuit 130 converts electric energy into a second direct current, and is configured to supply power to the second-type load 14. When the direct current to direct current conversion circuit 130 is configured to receive power supplied by the power battery 15, the power battery 15 outputs a high voltage direct current, and the direct current to direct current conversion circuit 130 is configured to convert the high voltage direct current into a first direct current or the second direct current, and output the first direct current or the second direct current to the vehicle-mounted power supply apparatus 10.

In an embodiment, the direct current to direct current conversion circuit 130 includes a primary-side circuit 131, a first transformer 1000, and a secondary-side circuit 132. The primary-side circuit 131 is configured to receive power supplied by the on-board charger 110 or the power battery 15. The first transformer 1000 is a low-voltage transformer, and the first transformer 1000 is configured to receive a current output by the primary-side circuit 131 and reduce a voltage value thereof. The secondary-side circuit 132 is configured to receive a current output by the first transformer 1000 and output the second direct current, that is, a low-voltage direct current. The primary-side circuit 131 is configured to convert the direct current into a square wave that alternates between a positive value and a negative value. After the square wave passes through the first transformer 1000, a voltage is reduced. Finally, the secondary-side circuit 132 converts the transformed square wave into the second direct current for output. For example, a voltage of the direct current is 100 V, a voltage of the square wave that alternates between a positive value and a negative value ranges from +100 V to -100 V, a voltage of the transformed square wave ranges from +12 V to -12 V, and a voltage of the second direct current is 12 V. In this application, the primary-side circuit 131, the first transformer 1000, and the secondary-side circuit 132 are disposed in the direct current to direct current conversion circuit 130, so that the vehicle-mounted power supply apparatus 10 provided in this application can convert the direct current output by the on-board charger 110 or the power battery 15 or the first direct current output by the direct current to direct current conversion circuit 130 into the second direct current, and supply power to the second-type load 14.

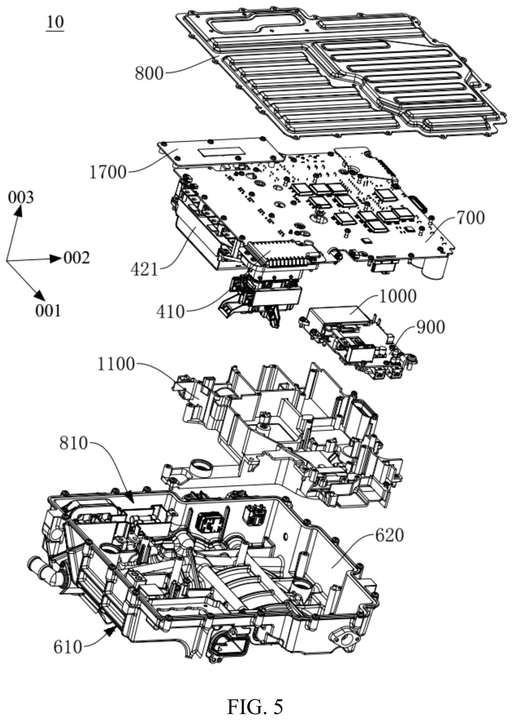

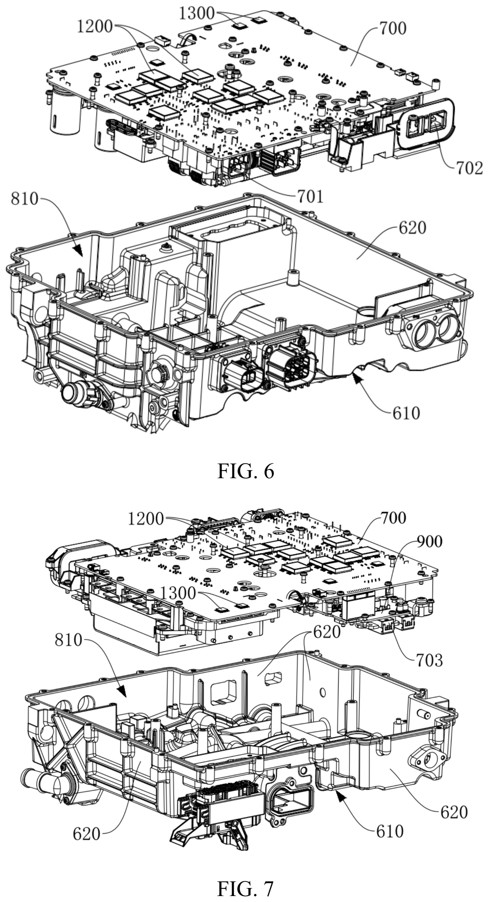

Refer to a diagram of a structure of a vehicle-mounted power supply apparatus 10 according to an embodiment of this application shown in FIG. 4, a diagram of an exploded structure of a vehicle-mounted power supply apparatus 10 according to an embodiment of this application shown in FIG. 5, and diagrams of exploded structures of a vehicle-mounted power supply apparatus 10 according to embodiments of this application from different perspectives shown in FIG. 6 and FIG. 7.

As shown in FIG. 4 to FIG. 7, the vehicle-mounted power supply apparatus 10 provided in this application includes a housing 600, a first circuit board 700, a second circuit board 900, and a cover plate 800. The housing 600 includes a housing bottom 610 and a plurality of side walls 620, and the plurality of side walls 620 surround the housing bottom 610 and form an accommodation groove 810. That is, the housing 600 of the vehicle-mounted power supply apparatus 10 includes the accommodation groove 810. The accommodation groove 810 is configured to accommodate the first circuit board 700 and the second circuit board 900. The cover plate 800 is configured to shield an opening of the accommodation groove 810, and the cover plate 800 is configured to enclose the first circuit board 700 and the second circuit board 900 together with the housing 600.

The first circuit board 700 and the second circuit board 900 are configured to fasten electrical components in the vehicle-mounted power supply apparatus 10. An electrical component fastened on the first circuit board 700 includes a first interface 701 and a second interface 702, and an electrical component fastened on the second circuit board 900 includes a third interface 703. The vehicle-mounted power supply apparatus 10 provided in this application includes a motor control unit 421, an on-board charger 110, and a direct current to direct current conversion circuit 130. An electrical component of the motor control unit 421, an electrical component of the on-board charger 110, and an electrical component of the direct current to direct current conversion circuit 130 are separately fastened on at least one of the first circuit board 700 and the second circuit board 900. The on-board charger 110 is configured to receive, through the first interface 701, an alternating current provided by an external power supply, and output, through the second interface 702, a direct current to charge the power battery 15. The motor control unit 421 is configured to receive, through the second interface 702, a direct current output by the power battery 15 of an electric vehicle 1, and output an alternating current to drive a drive motor 11 of the electric vehicle 1. The direct current to direct current conversion circuit 130 is configured to supply power to a vehicle-mounted load of the electric vehicle 1 through the third interface 703.

According to the all-in-one vehicle-mounted power supply apparatus 10 provided in this application, the first circuit board 700 and the second circuit board 900 are accommodated in the accommodation groove 810, and the electrical component of the motor control unit 421, the electrical component of the on-board charger 110, and the electrical component of the direct current to direct current conversion circuit 130 are fastened via the first circuit board 700 and the second circuit board 900. The all-in-one vehicle-mounted power supply apparatus 10 provided in this application is further electrically connected to the external power supply, the power battery 15, and the vehicle-mounted load through the first interface 701, the second interface 702, and the third interface 703 respectively. Therefore, the vehicle-mounted power supply apparatus 10 in this application integrates functions of driving the drive motor 11, receiving power supplied by the external power supply to charge the power battery 15, and receiving power supplied by the power battery 15 to supply power to the vehicle-mounted load.

The electrical component fastened on the first circuit board 700 includes the first interface 701 and the second interface 702, and the first circuit board 700 is configured to fasten the electrical component of the on-board charger 110. The electrical component fastened on the second circuit board 900 includes the third interface 703, and the second circuit board 900 is configured to fasten the electrical component of the direct current to direct current conversion circuit 130 and the electrical component of the motor control unit 421. According to the all-in-one vehicle-mounted power supply apparatus 10 provided in this application, electrical components are properly arranged via two circuit boards, thereby improving integration and reducing an overall size.

Specifically, the on-board charger 110 includes an input end and an output end. The input end of the OBC is connected to the external power supply to receive the alternating current provided by the external power supply. The output end of the OBC is configured to electrically connect to the power battery 15 via the direct current to direct current conversion circuit 130, to provide the direct current for the power battery 15. The direct current to direct current conversion circuit 130 is configured to receive the direct current provided by the on-board charger 110 or the power battery 15, and is configured to supply power to another electrical load in the electric vehicle 1 based on a required voltage.

In an embodiment, the vehicle-mounted power supply apparatus 10 provided in this application includes a vehicle control unit 410. The vehicle control unit 410 is configured to electrically connect to or communicatively connect to a part of other electrical components of the electric vehicle 1. The vehicle control unit 410 determines a driving intention of a driver by collecting signals such as a throttle pedal of the electric vehicle 1 and a brake pedal of the electric vehicle 1, and sends a control instruction to a controller in a power system of the electric vehicle 1 and a controller in a power battery 15 system after making corresponding determining based on comprehensive analysis, to control a running status of the electric vehicle 1. The vehicle control unit 410 is further configured to receive power supplied by the power battery 15 via the direct current to direct current conversion circuit 130.

In an embodiment, the electric vehicle 1 includes a drive motor 11, and the drive motor 11 is configured to be in transmission connection to one or more wheels 12 of the electric vehicle 1. The motor control unit 421 of the vehicle-mounted power supply apparatus 10 provided in this application is configured to electrically connect to the power battery 15 via the direct current to direct current conversion circuit 130, and is configured to electrically connect to the drive motor 11. The motor control unit 421 is configured to receive, via the direct current to direct current conversion circuit 130, power supplied by the power battery 15, and receive a control instruction from the vehicle control unit 410, to drive the drive motor 11 to output torque to drive the one or more wheels 12 of the electric vehicle 1 to rotate.

In an embodiment, the electric vehicle 1 includes an air conditioner. The air conditioner is configured to be fastened to a vehicle frame, and is configured to electrically connect to or communicatively connect to the vehicle-mounted power supply apparatus 10. The air conditioner is configured to receive a control instruction from the vehicle-mounted power supply apparatus 10 to adjust temperature and humidity in a vehicle compartment. For example, the air conditioner includes a compressor, the vehicle-mounted power supply apparatus 10 includes a compressor controller, the compressor is configured to electrically connect to the compressor controller, and the vehicle-mounted power supply apparatus 10 is configured to send a control instruction to the compressor via the compressor controller. The compressor is configured to receive the control instruction from the compressor controller to compress and convey a refrigerant in the air conditioner.

In an embodiment, the electric vehicle 1 includes a heater, the vehicle-mounted power supply apparatus 10 includes a heater controller, the heater is configured to electrically connect to the heater controller, and the vehicle-mounted power supply apparatus 10 sends a control instruction to the heater via the heater controller. The heater is configured to receive the control instruction from the heater controller to provide heat for the electric vehicle 1. For example, the heater may be a seat heater, that is, the heater is configured to provide heat for a seat of the electric vehicle 1, to improve use experience of a driver. In another embodiment, the heater may further be an air conditioner heater, and is configured to provide heat for a vehicle compartment.

In an embodiment, the power conversion component, the vehicle control unit, the motor control unit, the compressor controller, and the heater controller are used to form the electrical components in the vehicle-mounted power supply apparatus 10 provided in this application. In an embodiment, the vehicle-mounted power supply apparatus 10 provided in this application includes a second direct current to direct current conversion circuit 140. The second direct current to direct current conversion circuit 140 is configured to receive power supplied by the on-board charger 110 and the power battery 15, and allocate power to other electrical components in the electric vehicle 1 as required, to optimize energy distribution of the vehicle.

In an embodiment, the vehicle-mounted power supply apparatus 10 provided in this application includes a plurality of shielding plates 1100. The shielding plate 1100 is configured to shield electromagnetic interference between any two of the electrical component of the motor control unit 421, the electrical component of the on-board charger 110, and the electrical component of the direct current to direct current conversion circuit 130. The shielding plate 1100 is fastened between a bottom of the accommodation groove 810 and the first circuit board 700.

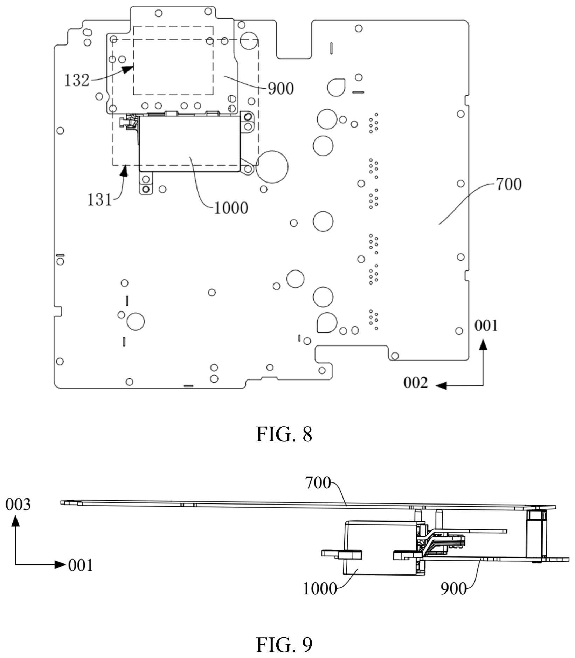

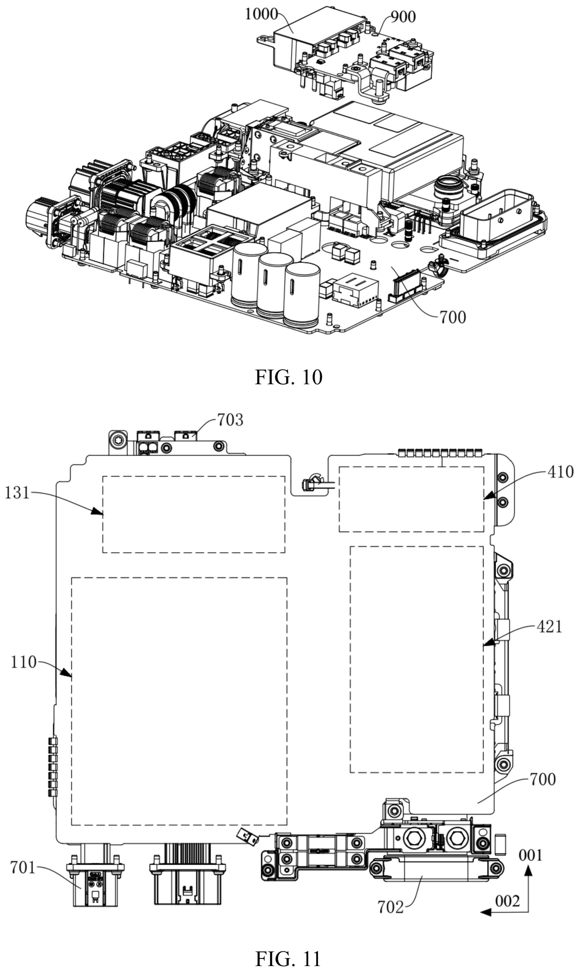

In an embodiment, the first circuit board 700 includes a plurality of magnetic components, and the first circuit board 700 is configured to connect to the second circuit board 900. The second circuit board 900 includes one or more capacitors 910, and the second circuit board 900 is configured to connect to the first transformer 1000. Specifically, the shielding plate 1100 is used to form a plurality of isolation cavities 1110, and the plurality of isolation cavities 1110 are configured to accommodate the plurality of magnetic components of the first circuit board 700. Specifically, refer to a diagram of a partial structure of a vehicle-mounted power supply apparatus 10 according to an embodiment of this application shown in FIG. 8, a diagram of a partial structure of a vehicle-mounted power supply apparatus 10 according to an embodiment of this application shown in FIG. 9, and a partial exploded diagram of a vehicle-mounted power supply apparatus 10 according to an embodiment of this application shown in FIG. 10.

In an embodiment, an area of the second circuit board 900 is less than a half of that of the first circuit board 700, and the second circuit board 900 is arranged between the housing bottom of the housing and the first circuit board 700. The area of the first circuit board 700 is larger, so that more electrical components can be integrated into the first circuit board 700, and the area of the second circuit board 900 is reduced to save internal space of the accommodation groove 810. The second circuit board 900 is arranged between the housing bottom of the housing and the first circuit board 700, so that space may be reserved between the first circuit board 700 and the housing bottom 610 of the housing 600, to accommodate a part of electrical components with a large size.

As shown in FIG. 8 to FIG. 10, the electrical component fastened on the first circuit board 700 further includes an electrical component of the primary-side circuit 131, the electrical component fastened on the second circuit board 900 further includes an electrical component of the secondary-side circuit 132, and the first transformer 1000 is configured to electrically connect the electrical component of the primary-side circuit 131 borne on the first circuit board 700 and the electrical component of the secondary-side circuit 132 borne on the second circuit board 900.

In this embodiment, the primary-side circuit 131 of the direct current to direct current conversion circuit 130 is electrically connected to the secondary-side circuit 132 via the first transformer 1000. The electrical component of the primary-side circuit 131 and the electrical component of the secondary-side circuit 132 are conveniently fastened on the first circuit board 700 and the second circuit board 900 respectively, and are electrically connected via the first transformer 1000. The first transformer 1000 has a large size, and the first transformer 1000 and the second circuit board 900 are together arranged between the first circuit board 700 and the housing bottom 610 of the housing 600. The all-in-one vehicle-mounted power supply apparatus 10 provided in this application has a more compact structure, which facilitates heat dissipation of the first transformer 1000.

In an embodiment, a height of the first transformer 1000 is less than a spacing between the first circuit board 700 and a groove bottom of the accommodation groove 810, and is greater than a spacing between the second circuit board 900 and the groove bottom of the accommodation groove 810. The second circuit board 900 and the first transformer 1000 are spaced in a first direction. The second circuit board 900 and the first transformer 1000 are disposed side by side in the first direction, to shorten a connection distance between the second circuit board 900 and the first transformer 1000.

In an embodiment, the first transformer 1000 is plug-connected to the first circuit board 700, and the first transformer 1000 is screw-connected to the second circuit board 900. The plug-connection between the first transformer 1000 and the first circuit board 700 facilitates installation, and the screw-connection between the first transformer 1000 and the second circuit board 900 is firm, so that the first transformer 1000 may be connected to the second circuit board 900 and then fastened on the first circuit board 700 together with the second circuit board 900.

In a third direction 003, the second circuit board 900 and the first circuit board 700 are sequentially stacked from bottom to top. The third direction 003 is a direction in which the first circuit board 700 and the second circuit board 900 are stacked. That is, the second circuit board 900 and the first circuit board 700 are disposed in parallel. The second circuit board 900 is located between the first circuit board 700 and the housing bottom 610. The area of the second circuit board 900 is less than a half of that of the first circuit board 700. An area of an orthographic projection of the second circuit board 900 on the cover plate 800 is less than a half of that of an orthographic projection of the first circuit board 700 on the cover plate 800.

The second circuit board 900 and the first circuit board 700 are disposed to be sequentially stacked, so that space of the vehicle-mounted power supply apparatus 10 provided in this application in a plane direction of the first circuit board 700 can be saved, and arrangement of the vehicle-mounted power supply apparatus 10 is more compact. Therefore, the vehicle-mounted power supply apparatus 10 provided in this application can implement a miniaturization design. In addition, the area of the second circuit board 900 is disposed to be less than a half of that of the first circuit board 700, and more electrical components can be borne on the first circuit board 700. In addition, the area of the second circuit board 900 can be reduced to save internal space of the accommodation groove 810, so that more components are arranged below the first circuit board 700.

In an embodiment, the housing bottom 610 of the housing 600 is configured to fasten the first transformer 1000. A height of the first transformer 1000 is less than a spacing between the first circuit board 700 and the housing bottom 610, and is greater than a spacing between the second circuit board 900 and the housing bottom 610. The second circuit board 900 and the first transformer 1000 are spaced in the first direction 001.

In the third direction 003, the first transformer 1000 is located between the upper PCB board and the housing bottom 610. The first transformer 1000 is fastened at the housing bottom 610, and is spaced to the first circuit board 700 in the third direction 003. That is, in the third direction 003, the height of the first transformer 1000 is less than the spacing between the first circuit board 700 and the housing bottom 610. In the first direction 001, the first transformer 1000 and the second circuit board 900 are spaced. In addition, in the third direction 003, the height of the first transformer 1000 is greater than the spacing between the second circuit board 900 and the housing bottom 610. The second circuit board 900 and the first transformer 1000 are disposed side by side in the first direction 001, to shorten a connection distance between the second circuit board 900 and the first transformer 1000 and optimize layout in the accommodation groove 810.

Refer to a diagram of a partial structure of a vehicle-mounted power supply apparatus 10 according to an embodiment of this application shown in FIG. 11.

In an embodiment, the electrical component fastened on the first circuit board 700 further includes the electrical component of the on-board charger 110, and the on-board charger 110 includes an alternating current to direct current conversion circuit. An input end of the alternating current to direct current conversion circuit is configured to receive the alternating current provided by the external power supply, and an output end of the alternating current to direct current conversion circuit is configured to output a direct current to the primary-side circuit 131 of the direct current to direct current conversion circuit 130 via an on-board circuit on the first circuit board 700. In the first direction, the electrical component of the on-board charger 110 is arranged between the first interface 701 and the electrical component of the primary-side circuit 131 of the direct current to direct current conversion circuit 130.

In this embodiment, the electrical component of the on-board charger 110 is fastened on the first circuit board 700. The output end of the alternating current to direct current conversion circuit is configured to output the direct current via the primary-side circuit 131. The electrical component of the on-board charger 110 and the primary-side circuit 131 are arranged in the first direction 001, and the electrical component of the on-board charger 110 and the primary-side circuit are close to each other and located on a same side of the first circuit board 700, so that the electrical component of the on-board charger 110 is electrically connected to the primary-side circuit 131, heat of the first circuit board 700 is concentrated, and a heat dissipation structure is conveniently arranged.

In an embodiment, the first circuit board 700 and the second circuit board 900 each include a plurality of power modules 1200, and the first circuit board 700 further includes a control chip 1300. The plurality of power modules 1200 borne on the first circuit board 700 are used to form at least the on-board charger 110 of the vehicle-mounted power supply apparatus 10 and the primary-side circuit 131 in the direct current to direct current conversion circuit 130. The plurality power modules 1200 borne on the second circuit board 900 are used to form the secondary-side circuit 132 in the direct current to direct current conversion circuit 130 of the vehicle-mounted power supply apparatus 10. The control chip 1300 is used to form at least the vehicle control unit 410 of the vehicle-mounted power supply apparatus 10.

It should be noted that the power module 1200 is a power electronic component that can implement a power conversion function, and includes but is not limited to an insulated gate bipolar transistor (Insulated Gate Bipolar Transistor,), a silicon carbide power transistor, a silicon transistor, a MOS transistor (Metal-Oxide-Semiconductor Field-Effect Transistor,), a diode, and the like.

In an embodiment, in the direction in which the first circuit board 700 and the second circuit board 900 are stacked, an orthographic projection of the lower-layer PCB 900 board on the first circuit board 700 at least partially overlaps an area in which the primary-side circuit 131 is located.

In an embodiment, in the direction in which the first circuit board 700 and the second circuit board 900 are stacked, an orthographic projection of the second circuit board 900 on the first circuit board 700 at least partially overlaps an area in which the plurality of power modules 1200 used to form the primary-side circuit 131 are located. The secondary-side circuit 132 borne on the second circuit board 900, the first transformer 1000, and the primary-side circuit 131 borne on the first circuit board 700 are all the direct current to direct current conversion circuit 130. The secondary-side circuit 132 borne on the second circuit board 900 is configured to connect to the first transformer 1000, and the first transformer 1000 is configured to connect to the primary-side circuit 131 borne on the first circuit board 700. The first transformer 1000 and the second circuit board 900 are disposed side by side in the first direction 001. In the third direction 003, an orthographic projection of the second circuit board 900 on the first circuit board 700 at least partially overlaps the area in which the primary-side circuit 131 is located. In this way, the second circuit board 900 and the first transformer 1000 may be disposed in an area close to the primary-side circuit 131 borne on the first circuit board 700, to shorten a connection distance of the direct current to direct current conversion circuit 130.

The control chip 1300 is disposed on the first circuit board 700, and is connected to a part of on-board circuits on the first circuit board 700. The control chip 1300 is used to form at least the vehicle control unit 410 of a vehicle-mounted apparatus. That is, the first circuit board 700 includes the vehicle control unit 410. The vehicle control unit 410 may further be connected to other electrical components in the vehicle-mounted power supply apparatus 10, to receive a signal or send a control instruction to the other electrical components in the vehicle-mounted power supply apparatus 10.

In an embodiment, the vehicle control unit 410 is fastened on a surface that is of the first circuit board 700 and that faces the cover plate 800. In an embodiment, the vehicle control unit 410 is fastened on a surface that is of the first circuit board 700 and that faces the housing bottom 610 of the housing.

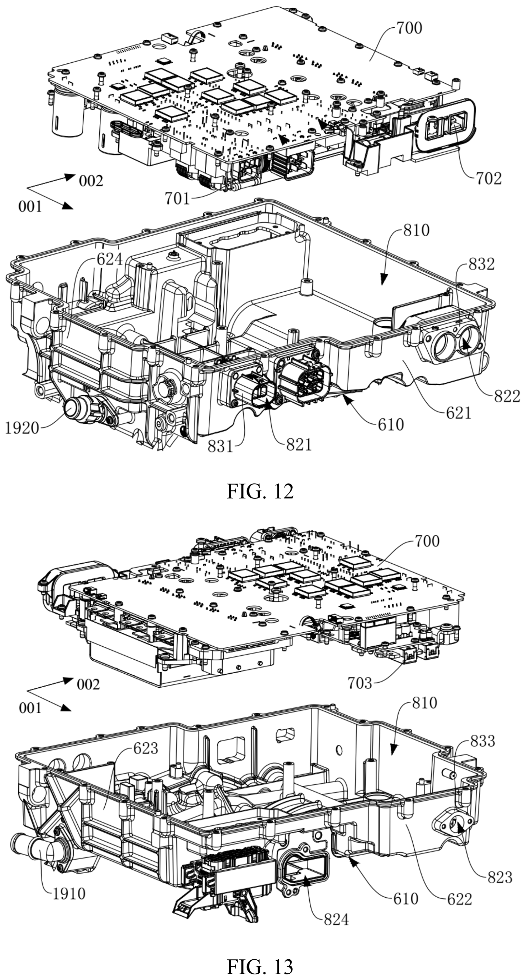

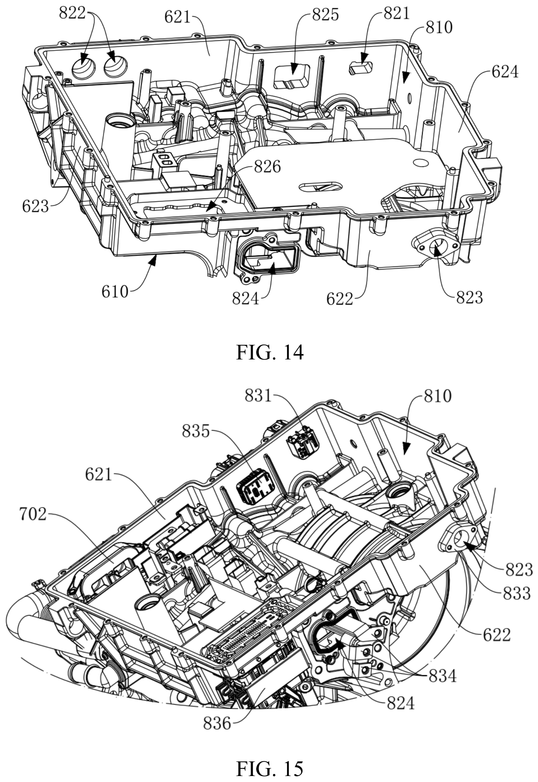

Refer to a partial exploded diagram of a vehicle-mounted power supply apparatus 10 according to an embodiment of this application shown FIG. 12, a partial exploded diagram of a vehicle-mounted power supply apparatus 10 according to an embodiment of this application shown in FIG. 13, a diagram of a partial structure of a vehicle-mounted power supply apparatus 10 according to an embodiment of this application shown in FIG. 14, and a diagram of a partial structure of a vehicle-mounted power supply apparatus 10 according to an embodiment of this application shown in FIG. 15.

The housing 600 includes the housing bottom 610 and four side walls 620. The four side walls 620 are disposed around the housing bottom 610, and the four side walls 620 and the housing bottom 610 together form the accommodation groove 810. The cover plate 800 is fastened to the housing 600 and covers the accommodation groove 810. The four side walls 620 specifically include a first side wall 621, a second side wall 622, a third side wall 623, and a fourth side wall 624. The first side wall 621 and the second side wall 622 are spaced in the first direction 001. In addition, the first side wall 621 is farther away from the second circuit board 900 than the second side wall 622. The third side wall 623 and the fourth side wall 624 are spaced in a second direction 002. In addition, the third side wall 623 is farther away from the on-board charger 110 than the fourth side wall 624.

In an embodiment, the accommodation groove 810 includes a first mounting hole 821, a second mounting hole 822, a third mounting hole 823, and a fourth mounting hole 824. The first mounting hole 821 and the second mounting hole 822 are distributed in the first side wall 621 of the accommodation groove 810, and the third mounting hole 823 and the fourth mounting hole 824 are distributed in the second side wall 622 of the accommodation groove 810. The first circuit board 700 and the second circuit board 900 are stacked between the first side wall 621 and the second side wall 622.

The first mounting hole 821 is configured to install a first connector 831, and the first connector 831 is configured to electrically connect the first interface 701 and the external power supply. The second mounting hole 822 is configured to install a second connector 832, and the second connector 832 is configured to electrically connect the second interface 702 and the power battery 15. The third mounting hole 823 is configured to install a third connector 833, and the third connector 833 is configured to electrically connect the third interface 703 and the vehicle-mounted load. A three-phase copper bar 834 of the vehicle-mounted power supply apparatus 10 is connected to the motor through the fourth mounting hole 824, and the vehicle-mounted power supply apparatus 10 supplies power to the drive motor 11 via the three-phase copper bar 834.

In an embodiment, a spacing between the first mounting hole 821 and the second mounting hole 822 in the first side wall 621 is greater than a spacing between the third mounting hole 823 and the fourth mounting hole 824 in the second side wall 622.

Each mounting hole is configured to install the connector, so that each interface of the electrical component communicates with the outside via the connector. The first mounting hole 821 and the second mounting hole 822 are located on a same side of the first circuit board 700, and are close to the on-board charger 110 in the first direction 001, so that the first interface 701 and the second interface 702 are electrically connected to the outside via the first connector 831 and the second connector 832 respectively. The third mounting hole 823 and the fourth mounting hole 824 are located on the other side of the first circuit board 700, and are close to the direct current to direct current conversion circuit 130 in the first direction 001, so that the third interface 703 is connected to the vehicle-mounted load via the third connector 833.

The first interface 701 and the second interface 702 are configured to transmit a high-voltage alternating current and a high-voltage direct current respectively, and a large distance between the first mounting hole 821 and the second mounting hole 822 can reduce interference between the high-voltage currents. The fourth mounting hole 824 is close to the drive motor 11, and a distance between the third mounting hole 823 and the fourth mounting hole 824 is shorter, so that the third connector 833 provides a low-voltage direct current for a component, for example, a rotating transformer of the drive motor 11.

Specifically, the first interface 701 is a high-voltage alternating current input interface, and the first interface 701 is configured to receive the high-voltage charging current provided by the external power supply for the vehicle-mounted power supply apparatus 10 in this application. The first interface 701 is further configured to electrically connect to the on-board charger 110. The first circuit board 700 is connected to the first interface 701 via the on-board charger 110 to receive the high-voltage charging current. The on-board charger 110 is configured to convert the received high-voltage charging current from a high-voltage alternating current into a high-voltage direct current, to supply power to other electrical components in the vehicle-mounted power supply apparatus 10 in this application.

The second interface 702 is a direct current bus interface, and the second interface 702 is configured to connect to the power battery 15, to receive a current of the power battery 15 or output a current to the power battery 15. The second interface 702 is further configured to electrically connect to the direct current to direct current conversion circuit 130. The direct current to direct current conversion circuit 130 is electrically connected to the second interface 702 and is electrically connected to the on-board charger 110. The direct current to direct current conversion circuit 130 is configured to receive power supplied by the on-board charger 110, and output the first direct current through the second interface 702 to charge the power battery 15. The vehicle-mounted power supply apparatus 10 is further connected to the second interface 702 via the direct current to direct current conversion circuit 130, to receive the current of the power battery 15 and supply power to other electrical components in the vehicle-mounted power supply apparatus 10.

The third interface 703 is a low-voltage direct current output interface. The third interface 703 is configured to connect to other loads in the electric vehicle 1. The third interface 703 is further configured to electrically connect to the secondary-side circuit 132. The secondary-side circuit 132 is connected to the third interface 703 and is electrically connected to the first transformer 1000. The secondary-side circuit 132 is configured to receive power supplied by the on-board charger 110 or the power battery 15, and output the second direct current through the third interface 703, to supply power to the second-type load 14 of the electric vehicle 1. That is, the secondary-side circuit 132 is configured to output the low-voltage direct current through the third interface 703, to supply power to other loads of the electric vehicle 1.

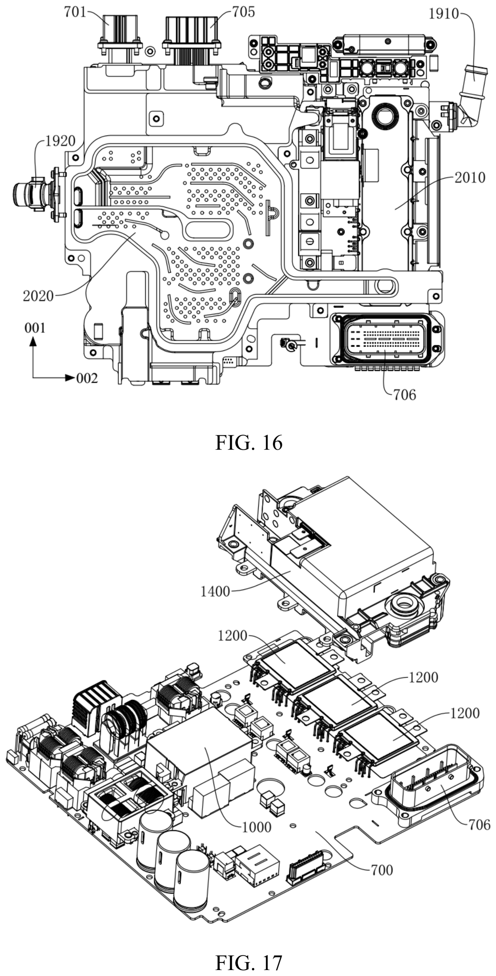

Refer to a partial diagram of a vehicle-mounted power supply apparatus 10 according to an embodiment of this application shown in FIG. 16.

In an embodiment, the accommodation groove 810 includes a coolant inlet 1910 and a coolant outlet 1920, the coolant inlet 1910 is distributed in the third side wall 623 of the accommodation groove 810, the coolant outlet 1920 is distributed in the fourth side wall 624 of the accommodation groove 810, the first circuit board 700 and the second circuit board 900 are stacked between the third side wall 623 and the fourth side wall 624, in the second direction 002, a distance between the coolant inlet 1910 and the second mounting hole 822 is less than a distance between the coolant outlet 1920 and the second mounting hole 822, and the second direction 002 is perpendicular to the first direction 001.

In this embodiment, the all-in-one vehicle-mounted power supply apparatus 10 provided in this application further dissipates heat through a coolant, and the coolant inlet 1910 and the coolant outlet 1920 are formed on the housing 600 for circulation of the coolant in the accommodation groove 810. The coolant inlet 1910 and the coolant outlet 1920 are located on two opposite side walls 620 of the housing 600 in the second direction 002, to avoid a plurality of mounting holes and a plurality of connectors in the first side wall 621 and the second side wall 622, thereby ensuring safety of the vehicle-mounted power supply apparatus 10.

If the coolant inlet 1910 is closer to the second mounting hole 822 than the coolant outlet 1920, the coolant inlet 1910 is closer to the motor control unit 421, and cooling effect of the motor control unit 421 is preferentially ensured.

Refer to a partial exploded diagram of a vehicle-mounted power supply apparatus 10 according to an embodiment of this application shown in FIG. 17.

In an embodiment, the electrical component fastened on the first circuit board 700 further includes the electrical component of the motor control unit 421, the electrical component of the motor control unit 421 includes a power module 1200, and the power module 1200 of the motor control unit 421 is fastened on a surface that is of the first circuit board 700 and that faces the bottom of the accommodation groove 810. An input end of the power module 1200 is configured to receive, through the second interface 702, the direct current provided by the power battery 15, and an output end of the power module 1200 is configured to output an alternating current to the drive motor 11.

In this embodiment, the electrical component of the motor control unit 421 is fastened on the first circuit board 700, so that the motor control unit 421 receives, through the second interface 702, power supplied by the power battery 15. The power module 1200 of the motor control unit 421 is fastened on a side that is of the first circuit board 700 and that faces the housing bottom 610 of the housing 600, so that the power module 1200 is electrically connected to the drive motor 11, and the all-in-one vehicle-mounted power supply apparatus 10 provided in this application has a more compact structure.

In an embodiment, in the second direction 002, the motor control unit 421 is arranged on a side that is of the on-board charger 110 and that faces the vehicle control unit 410. In the first direction 001, the motor control unit 421 is arranged on a side that is of the vehicle control unit 410 and that faces the on-board charger 110.

In this embodiment, the motor control unit 421 is disposed in space of the side that is of the vehicle control unit 410 and that faces the on-board charger 110 in the second direction 002, that is, space of the side that is of the vehicle control unit 410 and that faces the on-board charger 110 in the first direction 001, so that the vehicle-mounted power supply apparatus 10 provided in this application has a function of controlling the drive motor 11 of the electric vehicle 1, thereby improving integration of the vehicle-mounted power supply apparatus 10 provided in this application. The motor control unit 421 is configured to receive the current of the power battery 15 and convert the current into a high-voltage alternating current to drive the drive motor 11 of the electric vehicle 1 to operate.

In an embodiment, the plurality of power modules 1200 borne on the first circuit board 700 are further used to form the motor control unit 421 of the vehicle-mounted power supply apparatus 10. In the second direction 002, the power modules 1200 used to form the motor control unit 421 are arranged on a side that is of the plurality power modules 1200 used to form the on-board charger 110 and that faces the control chip 1300 used to form the vehicle control unit 410. In the first direction 001, the power modules 1200 used to form the motor control unit 421 are arranged on a side that is of the control chip 1300 used to form the vehicle control unit 410 and that faces the plurality of power modules 1200 used to form the on-board charger 110.

In an embodiment, in the first direction 001, the power modules 1200 are arranged between the second interface 702 and the fourth mounting hole 824.

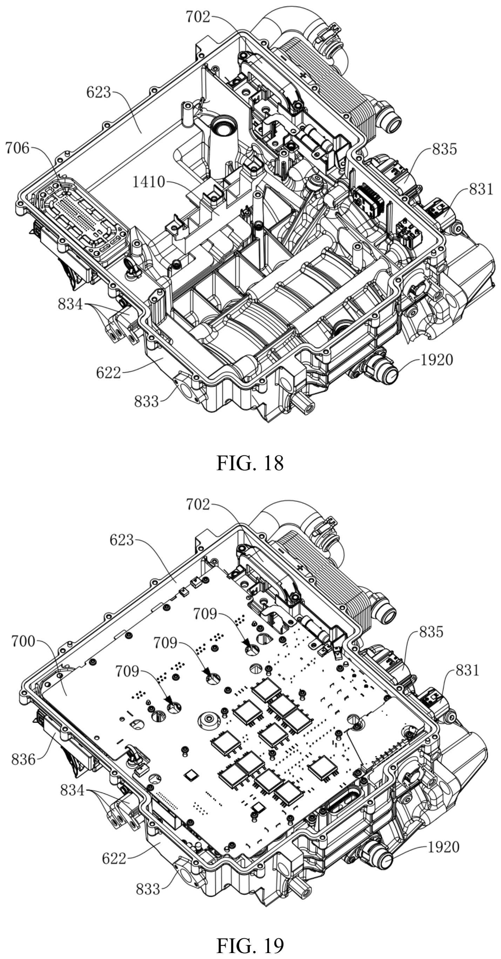

Refer to a diagram of a partial structure of a vehicle-mounted power supply apparatus 10 according to an embodiment of this application shown in FIG. 18, and a diagram of a partial structure of a vehicle-mounted power supply apparatus 10 according to an embodiment of this application shown in FIG. 19.

In an embodiment, the vehicle-mounted power supply apparatus 10 includes a three-phase copper bar adapter base 1410, the output end of the power module 1200 is connected to the three-phase copper bar 834 through the three-phase copper bar adapter base 1410, the alternating current output by the output end of the power module 1200 to the drive motor 11 passes through the three-phase copper bar adapter base 1410 and the three-phase copper bar 834, the three-phase copper bar adapter base 1410 is fastened between the power module 1200 and the bottom of the accommodation groove 810, one end of the three-phase copper bar adapter base 1410 is fastened to the output end of the power module 1200, the other end of the three-phase copper bar adapter base 1410 is connected to the three-phase copper bar 834 via three screws, and in a direction in which the bottom of the accommodation groove 810 and the first circuit board 700 are stacked, projections of the three screws fall into three corresponding through holes 709 in the first circuit board 700.

In this embodiment, the motor control unit 421 is electrically connected to the drive motor 11 via the three-phase copper bar 834, the three-phase copper bar 834 is located on the side that is of the first circuit board 700 and that faces the housing bottom 610 of the housing 600, and the three-phase copper bar adapter base 1410 is configured to electrically connect the three-phase copper bar 834 and the power module 1200 that are located on a same side, so that the vehicle-mounted power supply apparatus 10 has a more compact structure. The three through holes 709 in the first circuit board 700 are used to avoid the three screws used to connect the three-phase copper bar adapter base 1410 and the three-phase copper bar 834, to facilitate installation, removal, and maintenance between the three-phase copper bar adapter base 1410 and the three-phase copper bar 834.

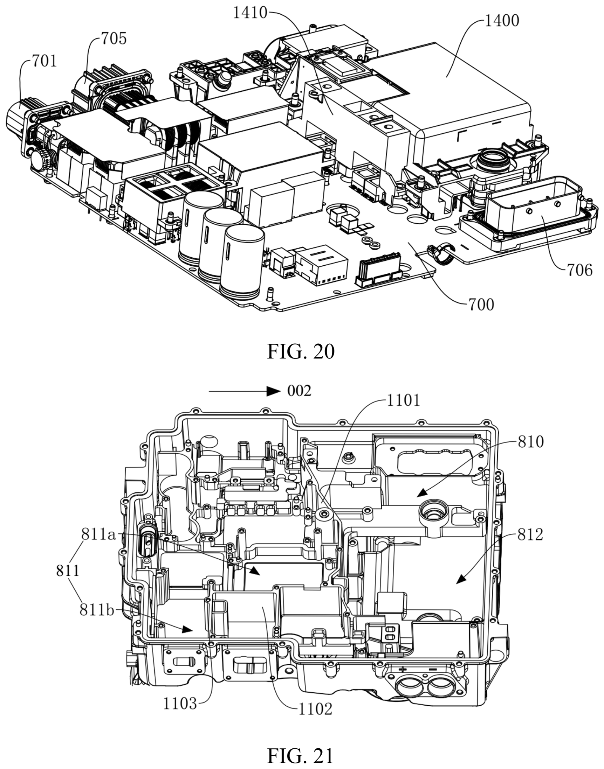

Refer to a diagram of a partial structure of a vehicle-mounted power supply apparatus 10 according to an embodiment of this application shown in FIG. 20.

In an embodiment, the vehicle-mounted power supply apparatus 10 includes one capacitor module 1400, the capacitor module 1400 is configured to reduce electromagnetic radiation of the direct current input by the power battery 15 to the motor control unit 421, the capacitor module 1400 includes a magnetic ring and a capacitor, the capacitor module 1400 and the three-phase copper bar adapter base 1410 are adjacently fastened between the first circuit board 700 and the bottom of the accommodation groove 810, and a projection of the capacitor module 1400 on the first circuit board 700 at least partially overlaps with the electrical component of the motor control unit 421.

In this embodiment, a side of the three-phase copper bar adapter base 1410 is configured to fasten one capacitor module 1400, and the capacitor module 1400 and the electrical component of the motor control unit 421 are at least partially overlapped, so that a transmission distance between the capacitor module 1400 and the motor control unit 421 can be shortened, and the vehicle-mounted power supply apparatus 10 has a more compact structure.

In an embodiment, the housing 600 is configured to fasten one capacitor module 1400 and the three-phase copper bar 834 of the motor control unit 421. The motor control unit 421 is configured to connect to the drive motor 11 via one capacitor module 1400 and the three-phase copper bar 834. One capacitor module 1400 and the three-phase copper bar 834 are arranged on a side that is of the first circuit board 700 and that faces the second circuit board 900.

In an embodiment, one capacitor module 1400 is configured to integrate a plurality of capacitors and a plurality of magnetic rings. The three-phase copper bar 834 is configured to pass through the housing bottom 610 of the housing 600 in the direction in which the first circuit board 700 and the second circuit board 900 are stacked, to connect to the drive motor 11.

The capacitor module 1400 is fastened on a side that is of the first circuit board 700 and that is away from the cover plate 800. The capacitor module 1400 includes the plurality of capacitors and the plurality of magnetic rings. The plurality of capacitors and the plurality of magnetic rings of the capacitor module 1400 are all connected to the first circuit board 700, and the plurality of capacitors of the capacitor module 1400 are further connected to the three-phase copper bar 834. A part of the plurality of capacitors of the capacitor module 1400 is the electrical component of the motor control unit 421, and the other part of the plurality of capacitors of the capacitor module 1400 includes a capacitor X and a capacitor Y. The capacitor X, the capacitor Y, and the plurality of magnetic rings are used to form a filter circuit. The filter circuit is configured to implement a shielding protection function for the motor control unit 421.

The capacitor module 1400 is configured to integrate the plurality of capacitors of the motor control unit 421, and is configured to integrate the plurality of capacitors and the plurality of magnetic rings of the filter circuit that is used to implement shielding protection of the motor control unit 421. The capacitors of the motor control unit 421, and the capacitor X, the capacitor Y, and the magnetic rings in the filter circuit are integrated, so that integration of the motor control unit 421 can be improved, and a size occupied by the motor control unit 421 in the housing 600 can be reduced, thereby improving overall integration of the vehicle-mounted power supply apparatus 10 provided in this application.

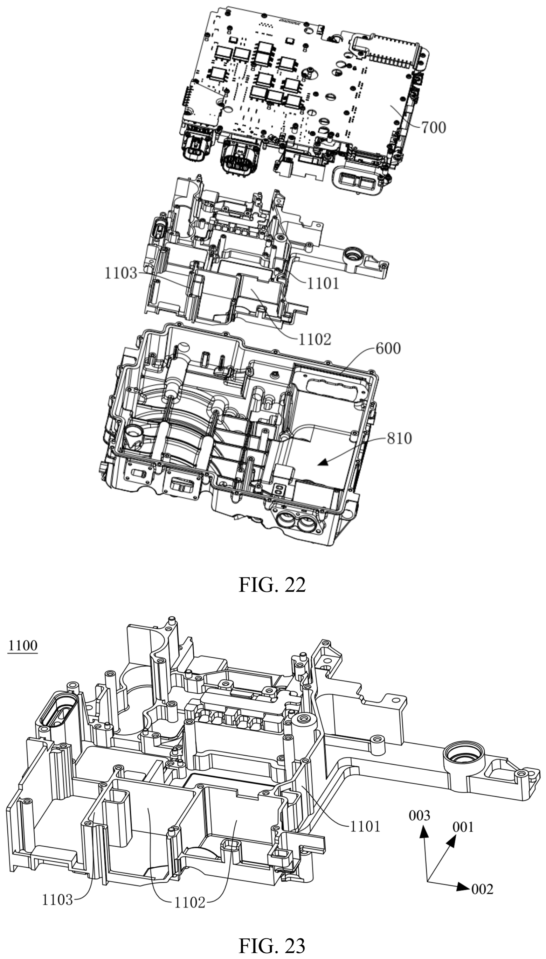

Refer to a diagram of a partial structure of a vehicle-mounted power supply apparatus 10 according to an embodiment of this application shown in FIG. 21, a partial exploded diagram of a vehicle-mounted power supply apparatus 10 according to an embodiment of this application shown in FIG. 22, and a diagram of a partial structure of a vehicle-mounted power supply apparatus 10 according to an embodiment of this application shown in FIG. 23.

In an embodiment, the vehicle-mounted power supply apparatus 10 further includes a shielding plate 1100. A first shielding wall 1101 of the shielding plate 1100 presses against a metal part that is on the first circuit board 700 and that faces the bottom of the accommodation groove 810, the electrical component of the motor control unit 421 is fastened on one side of the first shielding wall 1101, and the electrical component of the on-board charger 110 and the electrical component of the direct current to direct current conversion circuit 130 are fastened on the other side of the first shielding wall 1101. A second shielding wall 1102 of the shielding plate 1100 is arranged between the first interface 701 and the third interface 703, the electrical component of the on-board charger 110 is fastened on one side of the second shielding wall 1102, and the first transformer 1000 of the direct current to direct current conversion circuit 130 and the electrical component of the secondary-side circuit 132 are fastened on the other side of the second shielding wall 1102.

In this embodiment, the vehicle-mounted power supply apparatus 10 implements electromagnetic shielding between the electrical components via the shielding plate 1100. The first shielding wall 1101 roughly extends in the first direction 001, and is configured to shield electromagnetic interference between the motor control unit 421, the on-board charger 110, and the direct current to direct current conversion circuit 130. The second shielding wall 1102 roughly extends in the second direction 002, the second shielding wall 1102 is located on a side that is of the first shielding wall 1101 and that faces the on-board charger 110 and the direct current to direct current conversion circuit 130, and the second shielding wall 1102 is configured to shield electromagnetic interference between the on-board charger 110 and the direct current to direct current conversion circuit 130.

The metal part that is on the first circuit board 700 and that faces the housing bottom 610 of the housing 600 is configured to press against the shielding plate 1100, to avoid affecting shielding effect due to leakage of an electromagnetic signal from a gap between the first circuit board 700 and the shielding plate 1100.

In an embodiment, the shielding plate 1100 includes a third shielding wall 1103, the electrical component of the on-board charger 110 includes a plurality of common-mode inductors, the plurality of common-mode inductors are spaced in the second direction 002, and the third shielding wall 1103 roughly extends in the first direction 001 and is configured to be arranged between two adjacent common-mode inductors in the second direction 002.

In another description manner, the vehicle-mounted power supply apparatus 10 provided in this application includes the plurality of shielding plates 1100, and the plurality of shielding plates 1100 are accommodated in and fastened to the accommodation groove 810. The plurality of shielding plates 1100 are used to form the plurality of isolation cavities 1110. The plurality of isolation cavities 1110 are configured to accommodate a part of electrical components of the first circuit board 700. In the vehicle-mounted power supply apparatus 10 provided in this application, the plurality of shielding plates 1100 are configured to cooperate with each filter circuit, to form shielding protection for each electrical component in the vehicle-mounted power supply apparatus 10 provided in this application, and reduce electromagnetic interference between the electrical components.

The vehicle-mounted power supply apparatus 10 provided in this application accommodates the first circuit board 700, the second circuit board 900, and the first transformer 1000 via the housing 600 and the cover plate 800, to protect each component in the vehicle-mounted power supply apparatus 10. The first circuit board 700 and the second circuit board 900 are stacked, so that internal space of the housing 600 is effectively used, and an area of the vehicle-mounted power supply apparatus 10 in a plane direction of the first circuit board 700 is avoided to be excessively large. The plurality of isolation cavities 1110 are formed via the shielding plates 1100, and form shielding protection for each electrical component in the vehicle-mounted power supply apparatus 10 in cooperation with the plurality of magnetic components borne on the first circuit board 700. The capacitor 910 is borne on the second circuit board 900, and the second circuit board 900 is connected to the first transformer 1000 and the first circuit board 700, to ensure implementation of the electrical component on the second circuit board 900. The area of the first circuit board 700 is compared with the area of the second circuit board 900, so that more electrical components can be integrated into the first circuit board 700, and the area of the second circuit board 900 is reduced to save internal space of the accommodation groove 810.

Specifically, the shielding plate 1100 includes the first shielding wall 1101, and in the direction in which the first circuit board 700 and the second circuit board 900 are stacked, a height of the first shielding wall 1101 is lower than a height of a side wall 620 of the housing 600. The first circuit board 700 includes a metal part protruding towards the first shielding wall 1101, and in the direction in which the first circuit board 700 and the second circuit board 900 are stacked, the first shielding wall 1101 presses against the metal part. The first shielding wall 1101 extends from the housing bottom 610 of the housing 600 towards the first circuit board 700. In the third direction 003, a height of the first shielding wall 1101 is lower than a height of the side wall 620 of the housing 600. Correspondingly, the first circuit board 700 includes a metal part, and the metal part extends in the third direction 003 towards the housing bottom 610. In the plane direction of the first circuit board 700, a position and a shape of the metal part are approximately the same as those of the first shielding wall 1101. That is, an orthographic projection of the first shielding wall 1101 on the first circuit board 700 approximately overlaps with the metal part. A sum of heights of the first shielding wall 1101 and the metal part in the third direction 003 is greater than or equal to the spacing between the first circuit board 700 and the housing bottom 610, so that the first shielding wall 1101 and the metal part press against each other, and two isolation cavities are formed in the housing 600 through separation.

In the second direction 002, the first shielding wall 1101 and the metal part are arranged between the primary-side circuit 131 and the vehicle control unit 410, and the first shielding wall 1101 and the metal part are further arranged between the on-board charger 110 and the motor control unit 421.

The first shielding wall 1101 and the metal part are configured to extend in the first direction 001, and separate the accommodation groove 810 into a first isolation cavity 811 and a second isolation cavity 812 in the second direction 002. The first isolation cavity 811 is configured to accommodate at least the second circuit board 900, the first transformer 1000, the primary-side circuit 131, and the on-board charger 110. The second isolation cavity 812 is configured to accommodate at least the vehicle control unit 410 and the motor control unit 421. One capacitor module 1400 and the three-phase copper bar 834 that are used to form the motor control unit 421 are also located in the second isolation cavity 812. The first shielding wall 1101 and the metal part are configured to implement electromagnetic shielding between the two isolation cavities, to ensure that each electrical component operates reliably.

The metal part is fastened on the surface that is of the first circuit board 700 and that faces the housing bottom 610 of the housing, to ensure that the metal part is reliably attached to the surface of the first circuit board 700. The metal part presses against the first shielding wall 1101, so that poor attachment caused by bending deformation of the first circuit board 700 due to a large area can be eliminated, thereby ensuring shielding effect of the first shielding wall 1101 and the metal part. The metal part also reduces a flatness requirement of the first circuit board 700, thereby facilitating control of manufacturing costs of the first circuit board 700.

A height of the second shielding wall 1102 is lower than the height of the side wall 620 of the housing 600. The second shielding wall 1102 is configured to be arranged between the on-board charger 110 and the direct current to direct current conversion circuit 130 in the first direction 001. The second shielding wall 1102 is configured to separate a plurality of electrical components borne on the surface that is of the first circuit board 700 and that faces the housing bottom 610 of the housing. Specifically, the second shielding wall 1102 is located in the first isolation cavity 811. The second shielding wall 1102 is configured to extend in the second direction 002, and is configured to separate the first isolation cavity 811 into a first isolation sub-cavity 811a and a second isolation sub-cavity 811b in the first direction 001. The on-board charger 110 is located in the first isolation sub-cavity 811a, and is configured to connect to the first interface 701. The direct current to direct current conversion circuit 130 is located in the second isolation sub-cavity 811b, and is configured to connect to the third interface 703. The second shielding wall 1102 is configured to implement electromagnetic shielding between two sub-cavities: the first isolating sub-cavities 811a and the second isolating sub-cavities 811b, that is, is configured to implement electromagnetic shielding between the on-board charger 110 and the direct current to direct current conversion circuit 130, to ensure that each electrical component operates reliably.

In an embodiment, a metal part that is configured to press against the second shielding wall 1102 may also be fastened on the surface that is of the first circuit board 700 and that faces the housing bottom 610 of the housing, and the second shielding wall 1102 and the metal part together form better shielding effect.

A height of the third shielding wall 1103 is lower than the height of the side wall 620 of the housing 600. The third shielding wall 1103 is configured to separate the plurality of electrical components borne on the surface that is of the first circuit board 700 and that faces the housing bottom 610 of the housing. Specifically, the third shielding wall 1103 is located in the first isolation sub-cavity 811a, and the third shielding wall 1103 is configured to extend in the first direction 001, and is configured to separate two adjacent common-mode inductors located in the first isolation sub-cavity 811a. The third shielding wall 1103 is configured to implement electromagnetic shielding between the two adjacent common-mode inductors, to ensure that each electrical component operates reliably.

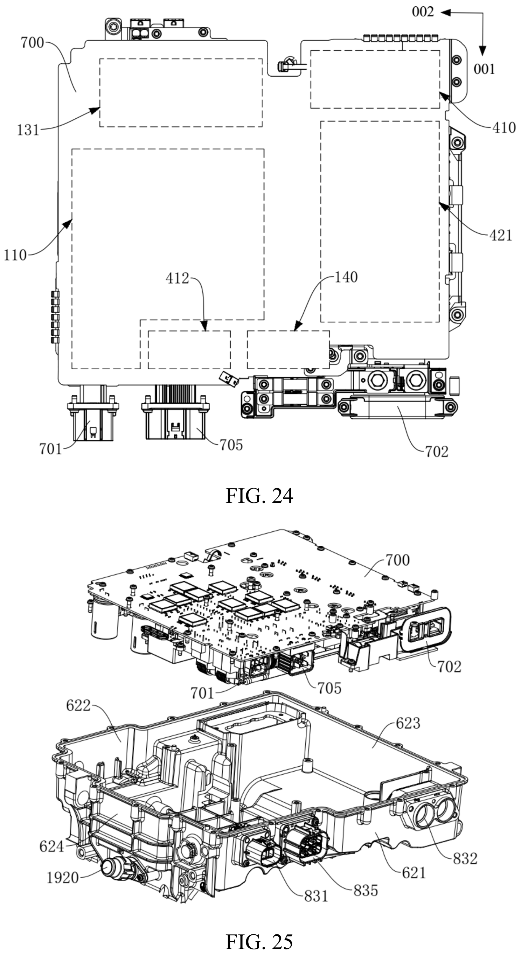

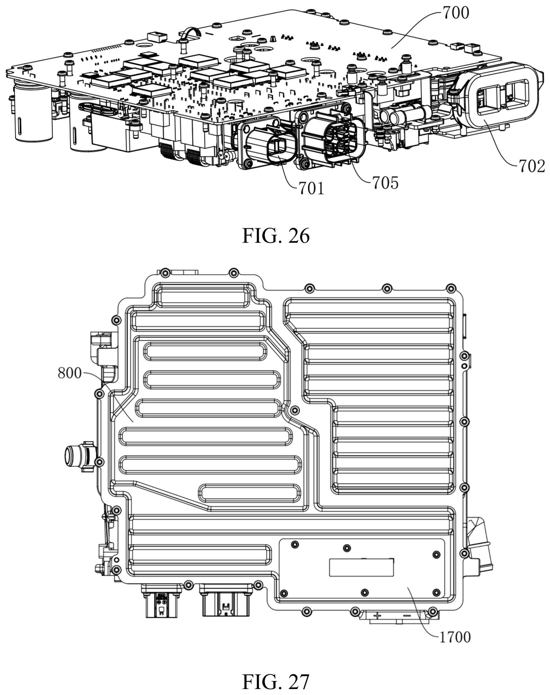

Refer to a diagram of a partial structure of a vehicle-mounted power supply apparatus 10 according to an embodiment of this application shown in FIG. 24, a partial exploded diagram of a vehicle-mounted power supply apparatus 10 according to an embodiment of this application shown in FIG. 25, and a diagram of a partial structure of a vehicle-mounted power supply apparatus 10 according to an embodiment of this application shown in FIG. 26.

In an embodiment, the vehicle-mounted power supply apparatus 10 includes a compressor controller 412 or a second direct current to direct current conversion circuit 140, the second direct current to direct current conversion circuit 140 is configured to output a direct current for power supply, the electrical component fastened on the first circuit board 700 further includes an electrical component of the compressor controller 412 or an electrical component of the second direct current to direct current conversion circuit 140 and a fifth interface 705, the accommodation groove 810 further includes a fifth mounting hole 825, the fifth mounting hole 825 is distributed on a side wall of the accommodation groove 810, the fifth mounting hole 825 is configured to install a fifth connector 835, the fifth connector 835 is configured to electrically connect an air conditioner compressor or a vehicle heater and the fifth interface 705, and the fifth interface 705 is fastened between the first interface 701 and the second interface 702.

In this embodiment, the first circuit board 700 is further configured to fasten the electrical component of the compressor controller 412 or the electrical component of the second direct current change circuit. In this application, the all-in-one vehicle-mounted power supply apparatus 10 is further configured to connect to a cockpit heater or the air conditioner compressor through the fifth interface 705, thereby further improving integration of the vehicle-mounted power supply apparatus 10.

In an embodiment, the fifth mounting hole 825 is distributed in the first side wall 621 of the accommodation groove 810, and a spacing between the first mounting hole 821 and the fifth mounting hole 825 in the first side wall 621 is less than a spacing between the second mounting hole 822 and the fifth mounting hole 825.

In an embodiment, the first circuit board 700 is further configured to communicate with the fifth interface 705 of the vehicle-mounted power supply apparatus 10, and the first circuit board 700 is configured to output the first direct current or the first alternating current through the fifth interface 705.

In an embodiment, the first circuit board 700 is configured to output the first direct current through the fifth interface 705, and the fifth interface 705 is configured to connect to the heater of the electric vehicle 1.

Specifically, in this embodiment, the plurality of electrical interfaces of the vehicle-mounted power supply apparatus 10 provided in this application include the fifth interface 705. The fifth interface 705 is configured to connect to the heater of the electric vehicle 1. The fifth interface 705 is a high-voltage direct current output interface, and the fifth interface 705 is configured to output the first direct current to supply power to the heater of the electric vehicle 1. The fifth interface 705 is further configured to connect to the first circuit board 700. The first circuit board 700 includes the second direct current to direct current conversion circuit 140. The second direct current to direct current conversion circuit 140 is configured to receive the current of the power battery 15 and supply power to each electrical component in the vehicle-mounted power supply apparatus 10. The second direct current to direct current conversion circuit 140 is connected to the fifth interface 705. That is, the first circuit board 700 is configured to connect to the fifth interface 705 via the second direct current to direct current conversion circuit 140, to connect to the heater of the electric vehicle 1, and output the first direct current to the heater.

In an embodiment, the electrical component of the compressor controller 412 fastened on the first circuit board 700 is configured to output the first alternating current through the fifth interface 705, the fifth interface 705 is configured to connect to the compressor of the electric vehicle 1, and the plurality of power modules 1200 borne on the first circuit board 700 are further used to form the compressor controller 412 of the vehicle-mounted power supply apparatus 10.

Specifically, in this embodiment, the plurality of electrical interfaces of the vehicle-mounted power supply apparatus 10 provided in this application include the fifth interface 705. The fifth interface 705 is configured to connect to the compressor of the electric vehicle 1. The fifth interface 705 is a high-voltage alternating current output interface, and the fifth interface 705 is configured to output the first alternating current to supply power to the compressor of the electric vehicle 1. The fifth interface 705 is fastened on the first circuit board 700. The first circuit board 700 includes the compressor controller 412 and the second direct current to direct current conversion circuit 140. The second direct current to direct current conversion circuit 140 is configured to receive the current of the power battery 15 and supply power to each electrical component in the vehicle-mounted power supply apparatus 10. The compressor controller 412 is configured to connect to the second direct current to direct current conversion circuit 140, and is configured to receive power supplied by the second direct current to direct current conversion circuit 140. The compressor controller 412 is further configured to connect to the fifth interface 705. That is, the second direct current to direct current conversion circuit 140 is configured to connect the fifth interface 705 and the compressor of the electric vehicle 1 via the compressor controller 412, to output the first alternating current to the compressor. The first circuit board 700 is connected to the fifth interface 705 via the second direct current to direct current conversion circuit 140 and the compressor controller 412 to connect to the compressor of the electric vehicle 1, and outputs the first alternating current to the compressor through the fifth interface 705 to drive the compressor to operate.

In an embodiment, the fifth interface 705 is used to separately output the first direct current and the first alternating current through integration. The fifth interface 705 may be separately connected to the heater and the compressor of the electric vehicle 1. The first circuit board 700 includes the second direct current to direct current conversion circuit 140 and the compressor controller 412, where the second direct current to direct current conversion circuit 140 is configured to directly connect to the fifth interface 705 to output the first direct current, and the second direct current to direct current conversion circuit 140 is further connected to the fifth interface 705 via the compressor controller to output the first alternating current.

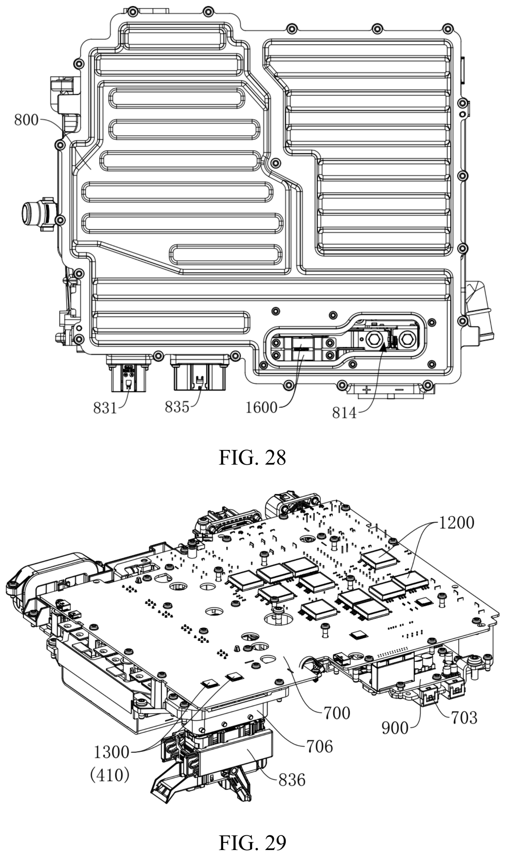

Refer to a diagram of a partial structure of a vehicle-mounted power supply apparatus 10 according to an embodiment of this application shown in FIG. 27, and a diagram of a partial structure of a vehicle-mounted power supply apparatus 10 according to an embodiment of this application shown in FIG. 28.

In an embodiment, the housing 600 of the vehicle-mounted power supply apparatus 10 further includes an end cover 1700, the cover plate 800 is configured to enclose the accommodation groove 810, the cover plate 800 includes a hollow area 814, and the end cover 1700 is configured to enclose the hollow area 814. The accommodation groove 810 is further configured to accommodate at least one fuse 1600, the at least one fuse 1600 is configured to electrically connect the second interface 702 and at least one of the electrical component of the motor control unit 421, the electrical component of the compressor controller 412, or the electrical component of the second direct current to direct current conversion circuit 140, and the at least one fuse 1600 is configured to perform disconnection protection on the at least one of the electrical component of the motor control unit 421, the electrical component of the compressor controller 412, or the electrical component of the second direct current to direct current conversion circuit 140. The fuse 1600 is configured to implement fault-cut-off of at least a part of electrical components in the vehicle-mounted power supply apparatus 10. The cover plate 800 and the first circuit board 700 are stacked, and in a direction in which the cover plate 800 and the first circuit board 700 are stacked, a projection area of the hollow area 814 covers the at least one fuse 1600.

In this embodiment, the first circuit board 700 is close to the cover plate 800, and the detachable end cover 1700 is disposed on the cover plate 800 to expose the fuse 1600, so that each fuse 1600 can be maintained and replaced without removing the entire cover plate 800, thereby improving maintenance convenience of the vehicle-mounted power supply apparatus 10 provided in this application. Specifically, the end cover 1700 is configured to be detachably fastened to the body of the cover plate 800 and shield the hollow area 814. Because the first circuit board 700 is close to the cover plate 800, and the detachable end cover 1700 is disposed on the cover plate 800 to expose the fuse 1600, so that each fuse 1600 can be maintained and replaced without removing the entire cover plate 800, thereby improving maintenance convenience of the vehicle-mounted power supply apparatus 10 provided in this application.

In an embodiment, the second direct current to direct current conversion circuit 140 includes at least one fuse 1600, and the fuse 1600 is configured to connect to the power battery 15. That is, the at least one fuse 1600 is used to form at least the second direct current to direct current conversion circuit 140 of the vehicle-mounted power supply apparatus 10.

In an embodiment, the at least one fuse 1600 is configured to connect the on-board charger 110 and the second interface 702. The on-board charger 110 is located in the on-board charger 110, and the second interface 702 is configured to connect to the power battery 15 of the electric vehicle 1. In this way, fault-cut-off from the on-board charger 110 to a battery pack can be implemented via the at least one fuse 1600.

In an embodiment, the at least one fuse 1600 is configured to connect the second interface 702 and the fifth interface 705. The second interface 702 is configured to connect to the power battery 15 of the electric vehicle 1, and the fifth interface 705 is configured to connect to the heater and/or the compressor of the electric vehicle 1. In this way, fault cut-off from the power battery 15 to the heater and fault cut-off from the power battery 15 to the compressor can be implemented via the at least one fuse 1600.

In an embodiment in which the fifth interface 705 is connected to the compressor controller, the at least one fuse 1600 is configured to connect the second interface 702 to the compressor controller. The second interface 702 is configured to connect to the power battery 15 of the electric vehicle 1, so that fault cut-off from the power battery 15 to the compressor controller can be implemented via the at least one fuse 1600.

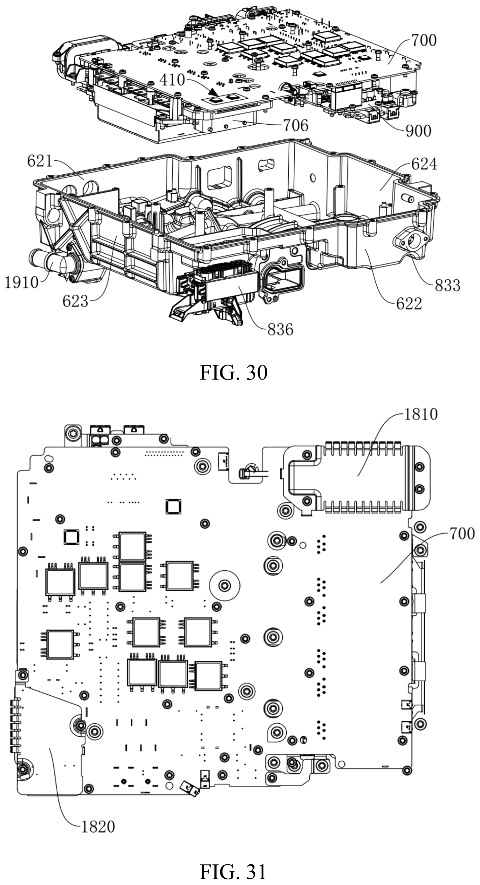

Refer to a diagram of a partial structure of a vehicle-mounted power supply apparatus 10 according to an embodiment of this application shown in FIG. 29, and a partial exploded diagram of a vehicle-mounted power supply apparatus 10 according to an embodiment of this application shown in FIG. 30.

In an embodiment, the vehicle-mounted power supply apparatus 10 includes the vehicle control unit 410. In the diagram of FIG. 29, the vehicle control unit 410 is represented via two control chips 1300. In this embodiment of this application, a specific quantity of control chips 1300 of the vehicle control unit 410 is not limited. The electrical component fastened on the first circuit board 700 further includes an electrical component of the vehicle control unit 410 and a sixth interface 706, the electrical component of the motor control unit 421 is fastened between the sixth interface 706 and the second interface 702, and the vehicle control unit 410 is configured to transmit a control signal through the sixth interface 706 to control a vehicle-mounted device. The accommodation groove 810 further includes a sixth mounting hole 826, the sixth mounting hole 826 is distributed at the bottom of the accommodation groove 810, the sixth mounting hole 826 is configured to install a sixth connector 836, and the sixth connector 836 is configured to electrically connect the sixth interface 706 and the vehicle-mounted device.

In this embodiment, the first circuit board 700 is further configured to fasten the electrical component of the vehicle control unit 410 and the sixth interface 706. In this application, the all-in-one vehicle-mounted power supply apparatus 10 is further configured to output the control signal through the sixth interface 706 to control the vehicle-mounted device of the electric vehicle 1, thereby further improving integration of the vehicle-mounted power supply apparatus 10. In an embodiment, the vehicle-mounted device of the electric vehicle 1 includes one or more of a throttle pedal, a brake pedal, a light, a steering device, and an air conditioner.

Specifically, the sixth interface 706 is configured to electrically connect one or more of the throttle pedal of the electric vehicle 1, the brake pedal of the electric vehicle 1, the light of the electric vehicle 1, the steering device of the electric vehicle 1, and the air conditioner of the electric vehicle 1. The sixth interface 706 is further configured to electrically connect to the first circuit board 700. The first circuit board 700 includes the vehicle control unit 410. The vehicle control unit 410 is electrically connected to the sixth interface 706. The first circuit board 700 is connected to the sixth interface 706 via the vehicle control unit 410 to connect to one or more of the throttle pedal of the electric vehicle, the brake pedal of the electric vehicle, the light of the electric vehicle, the steering device of the electric vehicle, and the air conditioner of the electric vehicle. The vehicle control unit 410 is configured to receive a signal or send a control instruction to the throttle pedal of the electric vehicle, the brake pedal of the electric vehicle, the light of the electric vehicle, the steering device of the electric vehicle, and the air conditioner of the electric vehicle.

In an embodiment, the primary-side circuit 131 and the vehicle control unit 410 are spaced in the second direction 002. In this embodiment, on the first circuit board 700, a spacing distance between the vehicle control unit 410 and the on-board charger 110 is long, so that impact of electromagnetic interference generated when the on-board charger 110 operates on the vehicle control unit 410 can be reduced.

In the vehicle-mounted power supply apparatus 10 provided in this application, the primary-side circuit 131 in the direct current to direct current conversion circuit 130 is spaced to the vehicle control unit 410 in the second direction 002, and is spaced to the on-board charger 110 and the direct current to direct current conversion circuit 130 in the first direction 001. Therefore, on the first circuit board 700, the spacing distance between the vehicle control unit 410 and the on-board charger 110 is long, so that impact of electromagnetic interference generated when the on-board charger 110 operates on the vehicle control unit 410 can be reduced.

In an embodiment, the vehicle-mounted power supply apparatus 10 includes a filter, the first circuit board 700 is configured to fasten an electrical component of the filter, and the filter is configured to implement electromagnetic shielding between other electrical components in the vehicle-mounted power supply apparatus 10. In an embodiment, the electrical component of the filter includes a plurality of magnetic components. Alternatively, the first circuit board 700 further includes a plurality of magnetic components, and the plurality of magnetic components are connected to circuits on the first circuit board 700 to form a part of the electrical components. The plurality of magnetic components are used to form a plurality of filter circuits with a part of the circuits on the first circuit board 700. The filter circuit may be used as a part of the electrical component, and is used to form electromagnetic shielding protection for other electrical components in the vehicle-mounted power supply apparatus 10 provided in this application.

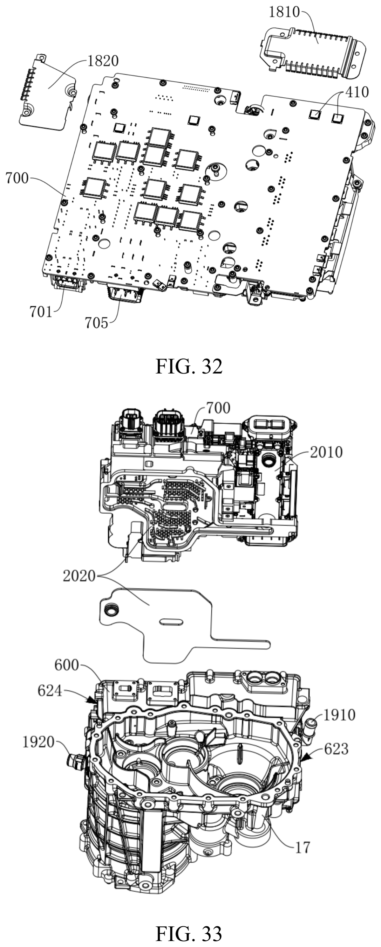

Refer to a diagram of a partial structure of a vehicle-mounted power supply apparatus 10 according to an embodiment of this application shown in FIG. 31, and a partial exploded diagram of a vehicle-mounted power supply apparatus 10 according to an embodiment of this application shown in FIG. 32.

In an embodiment, the vehicle-mounted power supply apparatus 10 provided in this application includes at least one shielding can, and the at least one shielding can is configured to be fastened on the first circuit board 700 to isolate electromagnetic interference. One shielding can is configured to cover a plurality of pins or pin headers that are electrically connected and that are of the sixth interface 706 and the sixth connector 836.

The vehicle-mounted power supply apparatus 10 provided in this application includes a first shielding can 1810. In the third direction 003, the first shielding can 1810 is located on a side that is of the first circuit board 700 and that is away from the second circuit board 900, and is fastened on the first circuit board 700. The first shielding can 1810 is configured to accommodate and shield the vehicle control unit 410, the sixth interface 706, and the sixth connector 836. Electromagnetic interference generated by the plurality of pins or pin headers that are electrically connected and that are of the sixth connector 836 and the sixth interface 706 is large. The first shielding can 1810 isolates the plurality of pins or pin headers that are electrically connected and that are of the sixth connector 836 and the sixth interface 706 on the first circuit board 700, so that electromagnetic interference caused by other electrical components in the vehicle-mounted power supply apparatus 10 to the vehicle control unit 410 can be reduced, thereby ensuring that the vehicle control unit 410 operates reliably.

In an embodiment, the first shielding can 1810 is configured to completely shield the vehicle control unit 410.

In an embodiment, one shielding can is configured to cover a plurality of pins or pin headers that are electrically connected and that are of the first interface 701 and the first connector 831.

The vehicle-mounted power supply apparatus 10 provided in this application includes a second shielding can 1820. In the third direction 003, the second shielding can 1820 is located on the side that is of the first circuit board 700 and that is away from the second circuit board 900, and is fastened on the first circuit board 700. The second shielding can 1820 is configured to cover the plurality of pins or pin headers that are electrically connected and that are of the first interface 701 and the first connector 831. Specifically, the plurality of pins or pin headers of the first interface 701 are configured to connect to the first connector 831. Electromagnetic interference generated by the plurality of pins or pin headers that are connected between the first connector 831 and the first interface 701. The second shielding can 1820 isolates the plurality of pins or pin headers on the first circuit board 700, so that electromagnetic protection can be performed on an area that is of the first circuit board 700 and that is close to the first interface 701, to ensure that the vehicle-mounted power supply apparatus 10 in this application meets a safety requirement. In this way, electromagnetic interference caused by other electrical components in the vehicle-mounted power supply apparatus 10 to the on-board charger 110 is further reduced, thereby ensuring that the on-board charger 110 operates reliably.

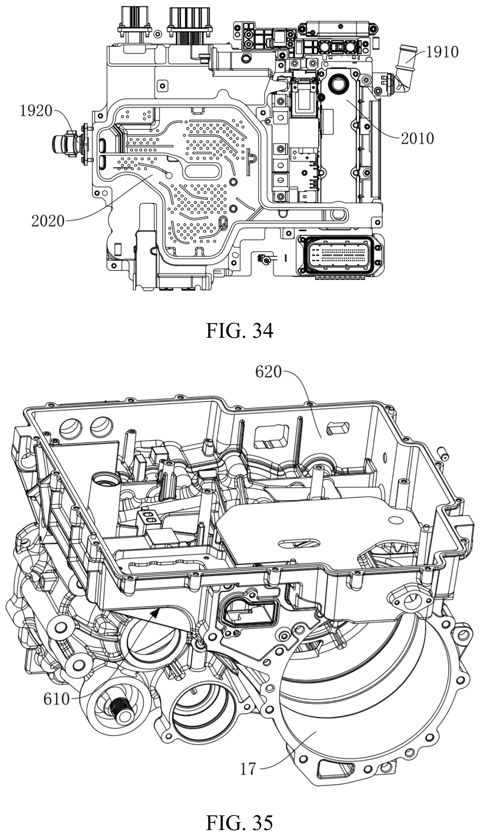

Refer to a diagram of a partial exploded structure of a vehicle-mounted power supply apparatus 10 according to an embodiment of this application shown in FIG. 33, and a partial diagram of a vehicle-mounted power supply apparatus 10 according to an embodiment of this application shown in FIG. 34.

In an embodiment, the coolant inlet 1910 is configured to communicate with the coolant outlet 1920 sequentially via a first heat dissipation plate 2010 and a second heat dissipation plate 2020. The first heat dissipation plate 2010 and the second heat dissipation plate 2020 are arranged between the housing 600 and the cover plate 800. An orthographic projection of the first heat dissipation plate 2010 on the first circuit board 700 at least partially overlaps with the drive motor control unit 421 of the vehicle-mounted power supply apparatus 10. An orthographic projection of the second heat dissipation plate 2020 on the first circuit board 700 at least partially overlaps with the on-board charger 110.

In this implementation, the vehicle-mounted power supply apparatus 10 provided in this application includes the first heat dissipation plate 2010 and the second heat dissipation plate 2020. The first heat dissipation plate 2010 and the second heat dissipation plate 2020 are arranged in the second direction 002. In the third direction 003, the first heat dissipation plate 2010 and the second heat dissipation plate 2020 are arranged between the first circuit board 700 and the housing bottom 610 of the housing 600. In the third direction 003, the orthographic projection of the first heat dissipation plate 2010 on the first circuit board 700 at least partially overlaps with the motor control unit 421 of the vehicle-mounted power supply apparatus 10. The orthographic projection of the second heat dissipation plate 2020 on the first circuit board 700 at least partially overlaps with the on-board charger 110 and the direct current to direct current conversion circuit 130. The third side wall 623 includes the coolant inlet 1910, and the fourth side wall 624 includes the coolant outlet 1920. The coolant inlet 1910 is disposed close to the motor control unit 421. The coolant inlet 1910 is configured to communicate with the coolant outlet 1920 sequentially via the first heat dissipation plate 2010 and the second heat dissipation plate 2020.

In this embodiment, the first heat dissipation plate 2010 is configured to dissipate heat for the motor control unit 421, and the second heat dissipation plate 2020 is configured to dissipate heat for the on-board charger 110 and the direct current to direct current conversion circuit 130. The coolant inlet 1910 close to the motor control unit 421 communicates with the coolant outlet 1920 sequentially via the first heat dissipation plate 2010 and the second heat dissipation plate 2020. Reliable heat dissipation of the motor control unit 421 can be ensured, and a heat dissipation function is implemented for both the on-board charger 110 and the direct current to direct current conversion circuit 130.

In an embodiment, the second heat dissipation plate 2020 and the shielding plate 1100 are integrated.

Refer to a diagram of a structure of a vehicle-mounted power supply apparatus 10 according to an embodiment of this application shown in FIG. 35.

This application further provides a powertrain 200. The powertrain 200 includes a drive motor 11 and the vehicle-mounted power supply apparatus 10 provided in any one of the foregoing embodiments. The drive motor 11 is electrically connected to the vehicle-mounted power supply apparatus 10 via a three-phase copper bar 834 of the vehicle-mounted power supply apparatus 10, and the vehicle-mounted power supply apparatus 10 outputs a three-phase current to drive the drive motor 11 to rotate. In an embodiment, an accommodation groove 810 of the vehicle-mounted power supply apparatus 10 and a housing of the drive motor 11 are of an integrated housing 600, and a bottom of the accommodation groove 810 shares a part of the housing 600 with the housing of the drive motor 11. The powertrain 200 provided in this application separately accommodates the vehicle-mounted power supply apparatus 10 and the drive motor 11 via the integrated housing 600, so that the powertrain 200 has a more compact structure, and the all-in-one vehicle-mounted power supply apparatus 10 provided in this application is electrically connected to the drive motor 11 via the three-phase copper bar 834.

Specifically, in a third direction 003, the drive motor 11 is located on a side that is of a housing bottom 610 in the vehicle-mounted power supply apparatus 10 in this application and that is away from a first circuit board 700. For ease of distinguishing, the housing of the drive motor 11 is defined as a second housing 17. The second housing 17 is configured to be fastened on the side that is of the housing bottom 610 of the housing 600 and that is away from the first circuit board 700. The second housing 17 is configured to accommodate and protect the drive motor 11. The housing 600 and the second housing 17 are of an integrated structure. That is, a side wall 620 of the housing 600 is configured to extend under the housing bottom 610 to form the second housing 17. The second housing 17 has a motor accommodating cavity that accommodates the drive motor 11. The housing 600 and the second housing 17 are integrally formed, so that a fastening connector and a positioning hole between the housing 600 and the second housing 17 can be omitted, and an overall size of the vehicle-mounted power supply apparatus 10 provided in this application is reduced.

In an embodiment, the housing 600 and the second housing 17 are separately processed, spliced, assembled, and formed. In this embodiment, structures of the housing 600 and the second housing 17 are simplified in a manner of separate processing, so that costs can be reduced.

In an embodiment, the housing bottom 610 of the housing 600 of the vehicle-mounted power supply apparatus 10 includes a mechanical limiting interface, and the housing 600 is configured to be fastened to the housing of the drive motor 11 through the mechanical limiting interface. This embodiment is also convenient for the three-phase copper bar 834 of the motor control unit 421 in the vehicle-mounted power supply apparatus 10 to electrically connect to the drive motor 11, to improve overall integration of the powertrain 200.

It is clear that a person skilled in the art can make various modifications and variations to this application without departing from the scope of this application. This application is intended to cover these modifications and variations of this application provided that they fall within the scope of protection defined by the following claims and their equivalent technologies.

## Claims

1. An all-in-one vehicle-mounted power supply apparatus, wherein the vehicle-mounted power supply apparatus is used in an electric vehicle, the vehicle-mounted power supply apparatus comprises a motor control unit, an on-board charger, and a direct current to direct current conversion circuit, a housing of the vehicle-mounted power supply apparatus comprises an accommodation groove, the accommodation groove is configured to accommodate a first circuit board and a second circuit board, an electrical component of the motor control unit, an electrical component of the on-board charger, and an electrical component of the direct current to direct current conversion circuit are separately fastened on at least one of the first circuit board and the second circuit board, an electrical component fastened on the first circuit board comprises a first interface and a second interface, and an electrical component fastened on the second circuit board comprises a third interface;
the on-board charger is configured to receive, through the first interface, an alternating current provided by an external power supply, and output, through the second interface, a direct current to charge a power battery;
the motor control unit is configured to receive, through the second interface, a direct current output by the power battery of the electric vehicle, and output an alternating current to drive a drive motor of the electric vehicle; and
the direct current to direct current conversion circuit is configured to supply power to a vehicle-mounted load of the electric vehicle through the third interface.

2. The vehicle-mounted power supply apparatus according to claim 1, wherein an area of the second circuit board is less than a half of that of the first circuit board, and the second circuit board is arranged between a housing bottom of the housing and the first circuit board.

3. The vehicle-mounted power supply apparatus according to claim 1 or 2, wherein the direct current to direct current conversion circuit comprises a primary-side circuit, a first transformer, and a secondary-side circuit, the electrical component fastened on the first circuit board further comprises an electrical component of the primary-side circuit, the electrical component fastened on the second circuit board further comprises an electrical component of the secondary-side circuit, and the first transformer is configured to electrically connect the electrical component of the primary-side circuit borne on the first circuit board and the electrical component of the secondary-side circuit borne on the second circuit board.

4. The vehicle-mounted power supply apparatus according to any one of claims 1 to 3, wherein the first transformer is plug-connected to the first circuit board, and is screw-connected to the second circuit board.

5. The vehicle-mounted power supply apparatus according to claim 3 or 4, wherein the electrical component fastened on the first circuit board further comprises the electrical component of the on-board charger, and the on-board charger comprises an alternating current to direct current conversion circuit;
an input end of the alternating current to direct current conversion circuit is configured to receive the alternating current provided by the external power supply, and an output end of the alternating current to direct current conversion circuit is configured to output a direct current to the primary-side circuit of the direct current to direct current conversion circuit via a circuit on the first circuit board; and
in a first direction, an electrical component of the alternating current to direct current conversion circuit is arranged between the first interface and the electrical component of the primary-side circuit of the direct current to direct current conversion circuit.

6. The vehicle-mounted power supply apparatus according to any one of claims 1 to 5, wherein the accommodation groove comprises a first mounting hole, a second mounting hole, a third mounting hole, and a fourth mounting hole, the first mounting hole and the second mounting hole are distributed on a first side wall of the accommodation groove, the third mounting hole and the fourth mounting hole are distributed on a second side wall of the accommodation groove, and the first circuit board and the second circuit board are stacked between the first side wall and the second side wall;
the first mounting hole is configured to install a first connector, and the first connector is configured to electrically connect the first interface and the external power supply;
the second mounting hole is configured to install a second connector, and the second connector is configured to electrically connect the second interface and the power battery;
the third mounting hole is configured to install a third connector, and the third connector is configured to electrically connect the third interface and the vehicle-mounted load;
a three-phase copper bar of the vehicle-mounted power supply apparatus is connected to the motor through the fourth mounting hole, and the vehicle-mounted power supply apparatus supplies power to the motor via the three-phase copper bar; and
a spacing between the first mounting hole and the second mounting hole in the first side wall is greater than a spacing between the third mounting hole and the fourth mounting hole in the second side wall.

7. The vehicle-mounted power supply apparatus according to claim 6, wherein the accommodation groove comprises a coolant inlet and a coolant outlet, the coolant inlet is distributed on a third side wall of the accommodation groove, the coolant outlet is distributed on a fourth side wall of the accommodation groove, the first circuit board and the second circuit board are stacked between the third side wall and the fourth side wall, in a second direction, a distance between the coolant inlet and the second mounting hole is less than a distance between the coolant outlet and the second mounting hole, and the second direction is perpendicular to the first direction.

8. The vehicle-mounted power supply apparatus according to any one of claims 1 to 7, wherein the electrical component fastened on the first circuit board further comprises the electrical component of the motor control unit, the electrical component of the motor control unit comprises a power module, and the power module is fastened on a surface that is of the first circuit board and that faces a bottom of the accommodation groove; and
an input end of the power module is configured to receive, through the second interface, the direct current provided by the power battery, and an output end of the power module is configured to output an alternating current to the motor.

9. The vehicle-mounted power supply apparatus according to claim 8, wherein the vehicle-mounted power supply apparatus comprises a three-phase copper bar adapter base, the output end of the power module is connected to the three-phase copper bar through the three-phase copper bar adapter base, the alternating current output by the output end of the power module to the motor passes through the three-phase copper bar adapter base and the three-phase copper bar, the three-phase copper bar adapter base is fastened between the power module and the bottom of the accommodation groove, one end of the three-phase copper bar adapter base is fastened to the output end of the power module, the other end of the three-phase copper bar adapter base is connected to the three-phase copper bar via three screws, and in a direction in which the bottom of the accommodation groove and the first circuit board are stacked, projections of the three screws fall into three corresponding through holes in the first circuit board.

10. The vehicle-mounted power supply apparatus according to claim 9, wherein the vehicle-mounted power supply apparatus comprises a capacitor module, the capacitor module is configured to reduce electromagnetic radiation of the direct current input by the power battery to the motor control unit, the capacitor module comprises a magnetic ring and a capacitor, the capacitor module and the three-phase copper bar adapter base are adjacently fastened between the first circuit board and the bottom of the accommodation groove, and a projection of the capacitor module on the first circuit board at least partially overlaps with the electrical component of the motor control unit.

11. The vehicle-mounted power supply apparatus according to any one of claims 1 to 10, wherein the vehicle-mounted power supply apparatus further comprises a shielding plate, the shielding plate is configured to shield electromagnetic interference between any two of the electrical component of the motor control unit, the electrical component of the on-board charger, and the electrical component of the direct current to direct current conversion circuit, and the shielding plate is fastened between the bottom of the accommodation groove and the first circuit board;
a first shielding wall of the shielding plate presses against a metal part that is on the first circuit board and that faces the bottom of the accommodation groove, the electrical component of the motor control unit is fastened on one side of the first shielding wall, and the electrical component of the on-board charger and the electrical component of the direct current to direct current conversion circuit are fastened on the other side of the first shielding wall; and
a second shielding wall of the shielding plate is arranged between the first interface and the third interface, the electrical component of the on-board charger is fastened on one side of the second shielding wall, and the first transformer of the direct current to direct current conversion circuit and the electrical component of the secondary-side circuit are fastened on the other side of the second shielding wall.

12. The vehicle-mounted power supply apparatus according to any one of claims 1 to 11, wherein the vehicle-mounted power supply apparatus comprises a compressor controller or a second direct current to direct current conversion circuit, the second direct current to direct current conversion circuit is configured to output a direct current for power supply, the electrical component fastened on the first circuit board further comprises an electrical component of the compressor controller or an electrical component of the second direct current to direct current conversion circuit and a fifth interface, the accommodation groove further comprises a fifth mounting hole, the fifth mounting hole is distributed on a side wall of the accommodation groove, the fifth mounting hole is configured to install a fifth connector, the fifth connector is configured to electrically connect an air conditioner compressor or a vehicle heater and the fifth interface, and the fifth interface is fastened between the first interface and the second interface.

13. The vehicle-mounted power supply apparatus according to any one of claims 1 to 12, wherein the housing of the vehicle-mounted power supply apparatus further comprises a cover plate and an end cover, the cover plate is configured to enclose the accommodation groove, the cover plate comprises a hollow area, and the end cover is configured to enclose the hollow area;
the accommodation groove is further configured to accommodate at least one fuse, the at least one fuse is configured to electrically connect the second interface and at least one of the electrical component of the motor control unit, the electrical component of the compressor controller, or the electrical component of the second direct current to direct current conversion circuit, and the at least one fuse is configured to perform disconnection protection on the at least one of the electrical component of the motor control unit, the electrical component of the compressor controller, or the electrical component of the second direct current to direct current conversion circuit; and
the cover plate and the first circuit board are stacked, and in a direction in which the cover plate and the first circuit board are stacked, a projection area of the hollow area covers the at least one fuse.

14. The vehicle-mounted power supply apparatus according to any one of claims 1 to 13, wherein the vehicle-mounted power supply apparatus comprises a vehicle control unit;
the electrical component fastened on the first circuit board further comprises an electrical component of the vehicle control unit and a sixth interface, the electrical component of the motor control unit is fastened between the sixth interface and the second interface, and the vehicle control unit is configured to transmit a control signal through the sixth interface to control a vehicle-mounted device; and
the accommodation groove further comprises a sixth mounting hole, the sixth mounting hole is distributed at the bottom of the accommodation groove, the sixth mounting hole is configured to install a sixth connector, and the sixth connector is configured to electrically connect the sixth interface and the vehicle-mounted device.

15. A powertrain, wherein the powertrain comprises a drive motor and the vehicle-mounted power supply apparatus according to any one of claims 1 to 14, an accommodation groove of the vehicle-mounted power supply apparatus and a housing of the drive motor are of an integrated housing, a bottom of the accommodation groove shares a part of the housing with the housing of the drive motor, the drive motor is connected to the vehicle-mounted power supply apparatus via a three-phase copper bar of the vehicle-mounted power supply apparatus, and the vehicle-mounted power supply apparatus outputs a three-phase current to drive the drive motor to rotate.
